(19)

Europäisches
Patentamt
European
Patent Office
Office européen
des brevets

(11) **EP 2 448 024 A1**

(12) **EUROPEAN PATENT APPLICATION**
published in accordance with Art. 153(4) EPC

(43) Date of publication:
**02.05.2012 Bulletin 2012/18**

(21) Application number: **10792128.0**

(22) Date of filing: **23.06.2010**

(51) Int Cl.:
**H01L 33/60** *(2010.01)*     **H01L 33/50** *(2010.01)*

(86) International application number:
**PCT/JP2010/060629**

(87) International publication number:
**WO 2010/150810 (29.12.2010 Gazette 2010/52)**

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **26.06.2009  JP 2009152072
30.07.2009  JP 2009178114
21.12.2009  JP 2009289358
21.01.2010  JP 2010010820
03.03.2010  JP 2010046514**

(71) Applicant: **FUJIFILM Corporation
Tokyo 106-0031 (JP)**

(72) Inventors:
• **HATANAKA Yusuke
Haibara-gun
Shizuoka 421-0396 (JP)**
• **HOTTA Yoshinori
Haibara-gun
Shizuoka 421-0396 (JP)**
• **UESUGI Akio
Haibara-gun
Shizuoka 421-0396 (JP)**

(74) Representative: **Bachelin, Karl Martin Raimund
Hoffmann Eitle
Patent- und Rechtsanwälte
Arabellastrasse 4
81925 München (DE)**

(54)   **LIGHT REFLECTING SUBSTRATE AND PROCESS FOR MANUFACTURE THEREOF**

(57)   A light reflecting substrate comprises at least: an insulating layer and a metal layer disposed in contact with the insulating layer. The total reflectivity of light in the wavelength range of more than 320 nm and not more than 700 nm is not less than 50% and the total reflectivity of light in the wavelength range of 300 nm to 320 nm is not less than 60%. The light reflecting substrate further improves the emission power of the light-emitting device when used as the substrate therefor.

FIG. 7

EP 2 448 024 A1

**Description**

TECHNICAL FIELD

The present invention relates to a light reflecting substrate having an insulating layer and a metal layer and being used for a light-emitting device. More specifically, the present invention relates to a light reflecting substrate used for a light-emitting diode (hereinafter, referred to as "LED") light-emitting device, and more particularly, to the improvement of a reflecting substrate of an LED light-emitting device.

BACKGROUND ART

As known white LED light-emitting devices, LED light-emitting devices illuminating a display device that performs color display using RGB color filters are typical and multi-color mixed type LED light-emitting devices are used. The multi-color mixed type LED light-emitting devices emit white light by causing three color LEDs of RGB to simultaneously emit light and perform the color display through the use of the white light and the color filters of the display device.

However, since the respective LENDS of RGB emit light, the multi-color mixed type LED light-emitting devices are high in color purities and have superior color rendering properties, but a large number of LEDs are required to obtain white light, thereby causing a problem in that costs increase.

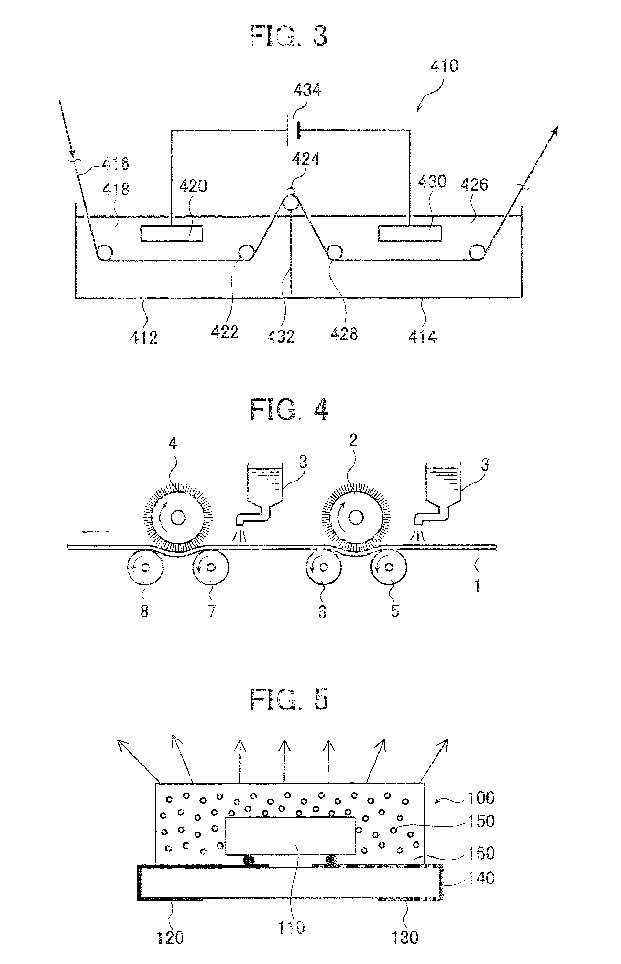

As a solution to the problem of the multi-color mixed type LED light-emitting devices, for example, phosphor color mixed type LED light-emitting devices are disclosed in Patent Literatures 1 and 2. FIG. 5 is a schematic view showing the configuration of a phosphor color mixed type white LED light-emitting device described in Patent Literatures 1 and 2, which may be incorporated in the configuration of the light-emitting device of the invention. FIG. 5 shows a white LED light-emitting unit 100. A blue LED 110 is face-down-bonded to a substrate 140 having electrodes 120 and 130 for external connection and the blue LED 110 is molded with a transparent resin 160 containing YAG fluorescent particles 150. Light excited by the YAG fluorescent particles 150 and afterglow of the blue LED 110 cause the white LED light-emitting unit 100 to emit white light in directions shown by arrows on the light-emitting surface side.

In the phosphor color mixed type LED light-emitting unit 100 including the blue LED 110 and the YAG fluorescent particles 150 used hitherto, it is considered preferable that countermeasures of increasing the thickness of the transparent resin 160 containing the YAG fluorescent particles 150, increasing the content of the fluorescent particles 150 of the transparent resin 160, or the like are carried out to enhance emission power of the white light. However, when such countermeasures are carried out, the transmission property of blue light from the blue LED 110 becomes poor and the emission power of the white light is not improved, depending on the thickness of the transparent resin 160 or the content of the fluorescent particles 150 of the transparent resin 160. Accordingly, in order to improve the emission power of the white light, it is desirable to further improve a phosphor color mixed type white light-emitting diode device.

For the purpose of improving the emission power in this way, for example, as shown in Patent Literature 3 or the like, a method of suppressing emission loss and improving emission power by using a metal substrate of aluminum as a light reflecting substrate is known. Particularly, referring to FIG. 2 of Patent Literature 3, the top surface of the metal substrate 11 is covered with an insulating resin 13 and a light-emitting device 15 is mounted on the top surface of a conductive pattern 14 formed on the top surface of the insulating resin 13. However, enhancement or improvement in reflectivity over the entire visible ray region, specifically, the whitening of a reflecting substrate itself, is desirable. Particularly, when a white resin is used as the insulating layer, there is a problem in that the white resin deteriorates due to heat radiation due to a large current at the time of enhancing the brightness of the light-emitting device.

It is required to design an LED light-emitting member so as to enhance directivity in the direction perpendicular to a light-emitting surface and a reflection characteristic having small viewing angle dependency is desirable.

CITATION LIST

PATENT LITERATURE

Patent Literature 1: JP 2998696 B;
Patent Literature 2: JP 11-87784 A;
Patent Literature 3: JP 2006-100753 A

SUMMARY OF INVENTION

TECHNICAL PROBLEMS

Therefore, an object of the invention is to provide a light reflecting substrate which can improve emission power of the white light.

SOLUTION TO PROBLEMS

The inventor carried out intensive research to achieve the above-mentioned object and found out that a light reflecting substrate including an insulating layer and a metal layer having irregularities of a specific size on the surface thereof is far superior in light reflectivity and the dependency of light reflectivity on a viewing angle in a wide wavelength region and at a wide viewing angle is small.
That is, the invention provides the following.

(1) A light reflecting substrate comprising at least: an insulating layer; and a metal layer disposed in contact with the insulating layer, wherein the total reflectivity of light in the wavelength range of more than 320 nm and not more than 700 nm is not less than 50% and the total reflectivity of light in the wavelength range of 300 nm to 320 nm is not less than 60%.

(2) The light reflecting substrate according to (1), wherein a surface of the light reflecting substrate has irregularities having an average wavelength of 0.01 to 100 $\mu$m.

(3) The light reflecting substrate according to (1) or (2), wherein a difference in surface area $\Delta S$ calculated by formula (A) is not less than 5% and not more than 90%:

$$\Delta S = [(S_x - S_0)/S_0] \times 100 \ (\%) \quad (A)$$

where $S_x$ represents the actual surface area of a 50 $\mu$m$\times$50 $\mu$m surface region of the light reflecting substrate as determined by three-point approximation from three-dimensional data on the surface region measured with an atomic force microscope at 512x512 points and $S_0$ represents the geometrically-measured surface area of the surface region.

(4) The light reflecting substrate according to any one of (1) to (3), wherein the metal layer is aluminum and the insulating layer is an anodized film of the aluminum.
(5) The light reflecting substrate according to any one of (1) to (4), wherein the light reflecting substrate is a light reflecting substrate reflecting light emitted from a light-emitting device toward an emitted-light observation surface.
(6) The light reflecting substrate according to any one of (1) to (5), wherein the metal layer has a shape having a pit and the insulating layer is formed on the surface of the shape having the pit.
(7) A method of manufacturing the light reflecting substrate according to any one of (1) to (6), comprising:

preparing an aluminum plate;
graining a surface of the aluminum plate; and
anodizing the grained surface to form the insulating layer.

(8) A method of manufacturing the light reflecting substrate according to any one of (1) to (6), comprising at least:

preparing an aluminum plate; and
graining a surface of the aluminum plate and then performing the following steps (a) and (b) in any order:

(a) forming an interconnect through-hole in which a light-emitting device is disposed and performing routing for chipping the substrate; and
(b) anodizing the grained surface to form the insulating layer.

(9) The light reflecting substrate according to (6), which is formed by superimposing at least two sheets of light reflecting substrates according to any one of (1) to (4) in which at least one through-hole is formed in one aluminum plate and no through-hole is formed in the other aluminum plate.

(10) The method of manufacturing a light reflecting substrate according to (8), wherein when the routing is performed so that a cutout portion for individually cutting chips is formed around a plurality of chips and a joint portion connecting the plurality of chips to the aluminum plate is formed in a part of the cutout portion, the routing includes a routing process of designing a portion of the aluminum plate serving as the joint portion so as to be thinner than a portion serving as a chip, cutting the cutout portion so as to leave the joint portion in the aluminum plate through the routing, then anodizing the aluminum plate, then cutting the joint portion to reduce or remove the area of the aluminum part formed in the thickness direction of the individual chips separated by cutting the joint.

(11) The method of manufacturing a light reflecting substrate according to (8) or (10), wherein the following steps (c) and (d) are performed in any order after the steps according to (8) or (10):

(c) forming a metal interconnect layer for transmitting an electrical signal to a light-emitting device and patterning the metal interconnect layer; and
(d) forming a metal layer in an electrode portion corresponding to a portion on which the light-emitting device is mounted again.

(12) A white light-emitting diode device having a blue light-emitting device in an upper layer of the light reflecting substrate according to any one of (1) to (6) and (9) and having a fluorescent emitter around and/or on the blue light-emitting device.

ADVANTAGEOUS EFFECTS OF INVENTION

As described below, according to the present invention, it is possible to provide a light reflecting substrate which has high heat dissipation and which can further enhance the emission power. In the light reflecting substrate according to the present invention, the dependency of light reflectivity on a viewing angle in a wide wavelength region and at a wide viewing angle is small.

BRIEF DESCRIPTION OF DRAWINGS

FIG. 1 is a graph showing an example of an alternating current waveform that may be used to perform electrochemical graining treatment in the manufacture of a light reflecting substrate of the invention.
FIG. 2 is a schematic view of a radial electrolytic cell that may be used in electrochemical graining treatment with alternating current in the manufacture of the light reflecting substrate of the invention.
FIG. 3 is a schematic view of an anodizing apparatus that may be used to perform anodizing treatment in the manufacture of the light reflecting substrate of the invention.
FIG. 4 is a schematic view showing the concept of a brush graining step that may be used to perform mechanical graining treatment in the manufacture of the light reflecting substrate of the invention.
FIG. 5 is a schematic view showing the configuration of a phosphor color mixed type white LED light-emitting device.
FIG. 6 is a graph showing the measurement results of the total reflectivity at 300 to 700 nm.
FIG. 7 is a schematic view showing a phosphor color mixed type white LED light-emitting device.
FIG. 8 is a graph showing the measurement results of the total reflectivity at 300 to 700 nm.
FIG. 9 is a sectional view showing another example of an LED light-emitting device employing the light reflecting substrate of the invention.

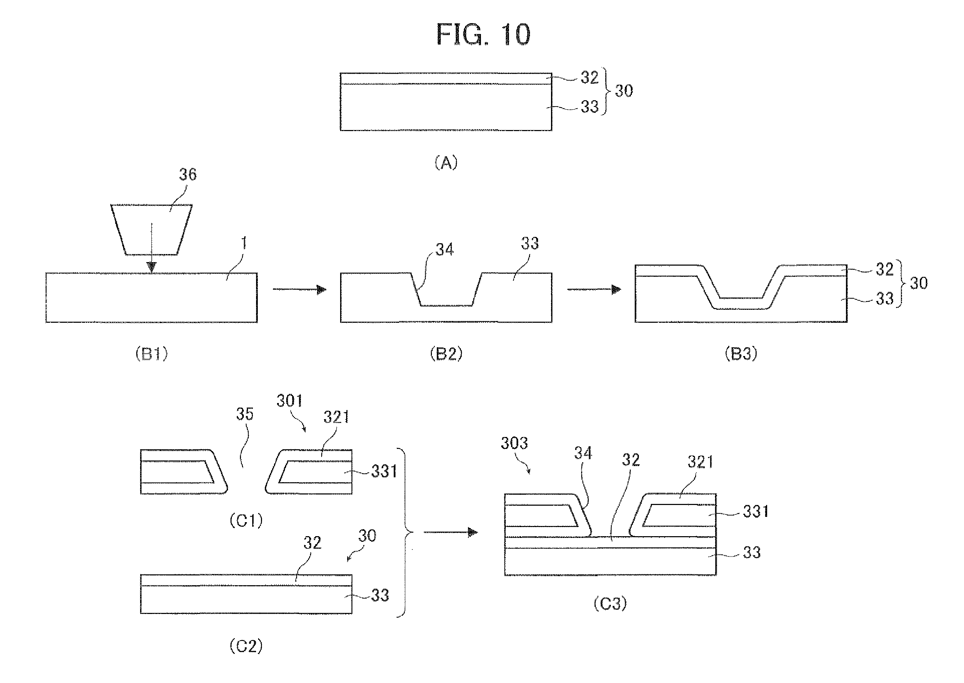

FIG. 10 is a sectional view showing an example of the light reflecting substrate of the invention. FIG. 10(A) is a sectional view of a light reflecting substrate in which an aluminum plate has a planar shape and an insulating layer has a planar shape. FIGS. 10(B1), 10(B2), and 10(B3) are sectional views of a light reflecting substrate in which an aluminum plate has a shape having a pit and an insulating layer is formed on the surface of the pit. FIGS. 10(C1), 10(C2), and 10(C3) are sectional views showing another example of a light reflecting substrate having the same shape as shown in FIGS. 10(B1), 10(B2), and 10(B3).

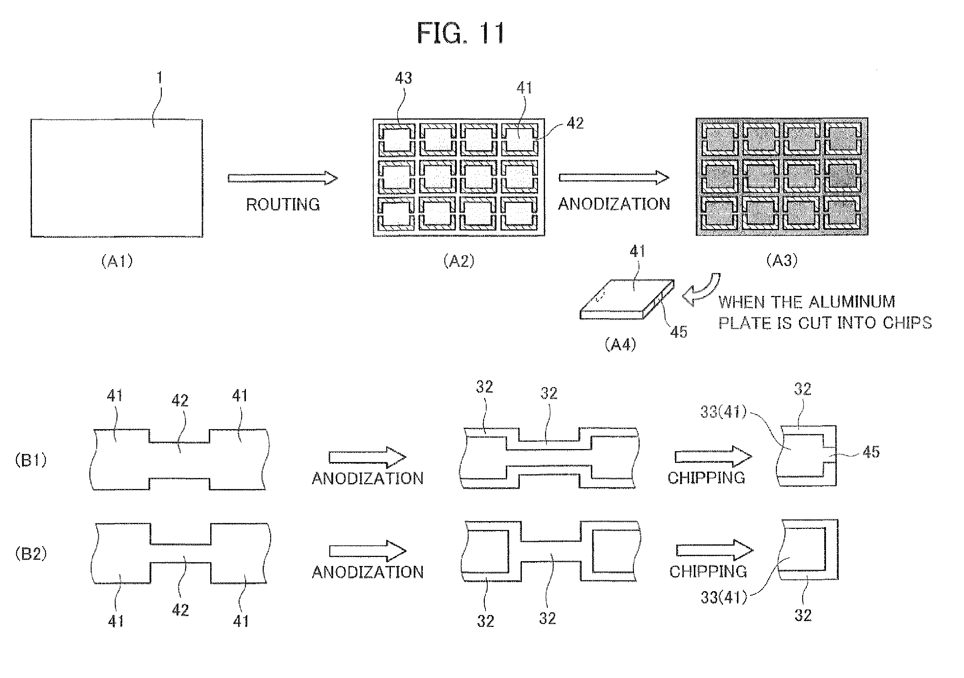

FIGS. 11(A1), 11(A2), 11(A3), and 11(A4) are schematic views showing a state where metal aluminum is exposed from a joint portion cut after routing and thus insulation performance is not sufficient in a routing method of manufacturing the light reflecting substrate of the invention. FIGS. 11(B1) and 11(B2) are sectional views showing the shape of a joint portion of the aluminum plate before the anodizing treatment for bonding an anodized film to the cut joint portion to maintain the insulation performance, the shape of the joint portion after the anodizing treatment, and the side surface of a light reflecting substrate chip after chipping.

DETAILED DESCRIPTION OF THE INVENTION

Hereinafter, a light reflecting substrate of the invention will be described in detail.
The light reflecting substrate of the invention includes an insulating layer and a metal layer formed in contact with the insulating layer and has light reflectivity of not less than 50% at a wavelength of more than 320 nm and not more than 700 nm and light reflectivity of not less than 60% at a wavelength of 300 nm to 320 nm. Here, the total reflectivity is measured, for example, by a spectrophotometer.

1. <Surface Profile>

In the light reflecting substrate of the invention, it is preferable so as to satisfy the above-mentioned reflectivity that the surface thereof has irregularities having an average wavelength of 0.01 to 100 $\mu$m. The surface may have a shape in which irregularities having different wavelengths are superimposed.
When the surface of the light reflecting substrate of the invention has such irregularities, it is estimated that a light diffusion effect can be improved and effects of light absorption /interference (effects causing loss in reflection) can be suppressed. Accordingly, the light reflecting substrate of the invention is superior in reflectivity.
In irregularities having an average wavelength of 5 to 100 $\mu$m (hereinafter, also referred to as a "large-wave structure"), the average wavelength is preferably in the range of 7 to 75 $\mu$m and the average wavelength is more preferably in the range of 10 to 50 $\mu$m, in that the light diffusion effect is further enhanced.
The surface of the light reflecting substrate of the invention has preferably a structure in which the irregularities have one structure of the following irregularities.
In irregularities having an average wavelength of 0.5 to 5 $\mu$m (hereinafter, also referred to as a "medium-wave structure"), the average wavelength is preferably in the range of 0.7 to 4 $\mu$m and the average wavelength is more preferably in the range of 1 to 3 $\mu$m, in that the light diffusion effect is enhanced and the light absorption effect is suppressed.
In irregularities having an average wavelength of 0.01 to 0.5 $\mu$m (hereinafter, also referred to as a "small-wave structure"), the average wavelength is preferably in the range of 0.015 to 0.4 $\mu$m and the average wavelength is more preferably in the range of 0.02 to 0.3 $\mu$m, in that the visible light interference effect is suppressed.
The surface of the light reflecting substrate of the invention has at least one selected from the group consisting of the large-wave structure, the medium-wave structure, and the small-wave structure. Two or more irregularity structures are preferably superimposed and all three irregularity structures are more preferably superimposed, in that the reflectivity can be further enhanced.
When the light reflecting substrate of the invention has the specific irregularities on the surface thereof, it is possible to take out uniform light at a wide viewing angle and the viewing angle dependency is small (a difference in reflectivity depending on the viewing angle is small).
When the surface of the light reflecting substrate of the invention has the specific irregularities, the close adhesion to a transparent resin having a fluorescent emitter to be described later is high due to the anchor effect of the irregularities and thus the heat dissipation is superior.
The surface of the light reflecting substrate of the invention has a difference in surface area $\Delta S$ represented by formula (1):
$$\Delta S = [(S_x - S_0)/S_0] \times 100 \ (\%) \quad (1)$$

wherein $S_x$ is the actual surface area of a 50 $\mu$m square surface region as determined by three-point approximation from three-dimensional data on the surface region measured with an atomic force microscope at 512 x 512 points and So is the geometrically measured surface area (apparent surface area) of the surface region, of preferably at least 5% but not more than 90%, more preferably at least 10% but not more than 80%, and even more preferably at least 20% but not more than 70% in terms of improving the whiteness of the reflecting substrate (improving the scattering property).
The difference in surface area $\Delta S$ is one of the factors that show the magnitude of the irregularities at the surface of the light reflecting substrate. When $\Delta S$ takes a larger value, more light can be scattered.
In the invention, the surface profile is measured with the atomic force microscope (AFM) to obtain three-dimensional data to thereby determine $\Delta S$. Measurement can be carried out, for example, under the following conditions. That is, a 1cm square sample is cut out from the light reflecting substrate and placed on a horizontal sample holder on a piezo scanner. A cantilever is made to approach the surface of the sample. When the cantilever reached the zone where interatomic forces are appreciable, the surface of the sample is scanned in the X and Y directions and the surface topography of the sample is read based on the displacement in the Z direction. A piezo scanner capable of scanning 150 $\mu$m in the X and Y directions and 10 $\mu$m in the Z direction is used. A cantilever having a resonance frequency of 120 to 150 kHz and a spring constant of 12 to 20 N/m (e.g., SI-DF20 manufactured by NANOPROBE) is used, with measurement being carried out in the dynamic force mode (DFM). The three-dimensional data obtained is approximated by the least-squares method to compensate for slight tilting of the sample and determine a reference plane. Measurement involves obtaining values of 50 $\mu$m square regions on the surface of the sample at 512 by 512 points. The resolution is 1.9 $\mu$m in the X and Y directions, and 1 nm in the Z direction. The scan rate is 60 $\mu$m/s.

Using the three-dimensional data ((x,y)) obtained above, sets of adjacent three points are selected and the surface areas of microtriangles formed by the sets of three points are summated, thereby giving the actual surface area $S_X$. The difference in surface area $\Delta S$ is then calculated from the resulting actual surface area $S_X$ and the geometrically measured surface area So using formula (1) above.

<Light reflecting substrate having cavity structure and method of manufacturing light reflecting substrate having cavity structure using two light reflecting substrates of the invention>

The light reflecting substrate of the invention is not particularly limited in shape. For example, as shown in FIG. 10(A), in the light reflecting substrate 30, an aluminum plate as the metal layer 33 may have a planar shape and the insulating layer 32 may have a planar shape. As shown in FIG. 10(B2), the light reflecting substrate may have a shape having a pit 34. When an LED device is mounted on the pit 34, it is possible to effectively use the light reflection of the side surface of the pit of the light reflecting substrate. FIGS. 10(B2) and 10(B3) are sectional views of the light reflecting substrate in which the aluminum plate as the metal layer has a shape having a pit 34 (cavity) and the insulating layer 32 is formed on the surface of the pit. The method of manufacturing the light reflecting substrate of the invention shown in FIG. 10(B3) is not limited. For example, as shown in FIGS. 10(B1) and 10(B2), a mold 36 may be pressed in the arrow direction to form the metal layer 33 having a pit 34 in the aluminum plate 1. FIG. 10(B2) is a sectional view showing a state where the pit 34 is formed in the metal layer 33. By anodizing the aluminum plate having the shape shown in FIG. 10(B2), the light reflecting substrate 30 having the insulating layer 32 and the metal layer 33 shown in FIG. 10(B3) can be manufactured.

FIGS. 10(C1), 10(C2), and 10(C3) are sectional views showing another example of the method of manufacturing a light reflecting substrate having the same shape as shown in FIGS. 10(B1) 10(B2), and 10(B3). For this light reflecting substrate, two sheets of a light reflecting substrate 30 not including a through-hole but including at least the insulating layer 32 and the metal layer 33 as shown in FIG. 10(C2) and another light reflecting substrate 301 including a through-hole 35 and including an insulating layer 321 and a metal layer 331 as shown in FIG. 10(C1) are prepared. Then, as shown in FIG. 10(C3), by superimposing two sheets of light reflecting substrates, a light reflecting substrate 303 having a pit 34 is formed. Two sheets of light reflecting substrates may be bonded to each other. The light reflecting substrate 301 shown in FIG. 10(C1) may be manufactured by preliminarily opening the through-hole 35 in the aluminum plate, anodizing the resultant, and then forming the insulating layer 321 thereon. Since the through-hole can be formed by low-cost drilling and the control of the shape or size of the through-hole is very simple, it is possible to manufacture a light reflecting substrate having the same cavity structure as in the past with a low cost by superimposing or bonding two sheets of substrates in work on or to each other, as described above.

A light reflecting substrate employing an alumite substrate obtained by anodizing aluminum, which is very suitable for the light reflecting substrate of the invention, will be described below. A light reflecting substrate including an alumina layer formed of anodized aluminum as the insulating layer and a metal layer of aluminum continuous therefrom is high in light reflectivity and superior in heat resistance and weather resistance.

2. <Aluminum Plate>

A known aluminum plate may be used to manufacture the light reflecting substrate in the invention. The aluminum plate used in the invention is made of a dimensionally stable metal composed primarily of aluminum; that is, aluminum or aluminum alloy. Aside from plates of pure aluminum, alloy plates composed primarily of aluminum and containing small amounts of other elements may also be used.

In the specification, various supports made of aluminum or aluminum alloy as described above are referred to generically as "aluminum plate." Other elements which may be present in the aluminum alloy include silicon, iron, copper, manganese, magnesium, chromium, zinc, bismuth, nickel and titanium. The content of other elements in the alloy is not more than 10 wt%.

Aluminum plates that may be used in the invention are not specified as to composition, but include known materials that appear in the 4th edition of Aluminum Handbook published in 1990 by the Japan Light Metal Association, such as aluminum plates having the designations JIS A1050, JIS A1100 and JIS A1070, and manganese-containing aluminum-manganese-based aluminum plates having the designation JIS A3004 and International Alloy Designation 3103A. Aluminum-magnesium alloys and aluminum-manganese-magnesium alloys (JIS A3005) composed of the above aluminum alloys to which at least 0.1 wt% of magnesium has been added may also be used to increase the tensile strength. Aluminum-zirconium alloys and aluminum-silicon alloys which additionally contain zirconium and silicon, respectively may also be used. Use may also be made of aluminum-magnesium-silicon alloys.

JIS 1050 materials are mentioned in JP 59-153861 A, JP 61-51395 A, JP 62-146694 A, JP 60-215725 A, JP 60-215726 A, JP 60-215727 A, JP 60-216728 A, JP 61-272367 A, JP 58-11759 A, JP 58-42493 A, JP 58-221254 A, JP 62-148295 A, JP 4-254545 A, JP 4-165041 A, JP 3-68939 B, JP 3-234594 A, JP 1-47545 B, JP 62-140894 A, JP 1-35910 B and JP 55-28874 B.

JIS 1070 materials are mentioned in JP 7-81264 A, JP 7-305133 A, JP 8-49034 A, JP 8-73974 A, JP 8-108659 A and JP 8-92679 A.

Aluminum-magnesium alloys are mentioned in JP 62-5080 B, JP 63-60823 B, JP 3-61753 B, JP 60-203496 A, JP 60-203497 A, JP 3-11635 B, JP 61-274993 A, JP 62-23794 A, JP 63-47347 A, JP 63-47348 A, JP 63-47349 A, JP 64-1293 A, JP 63-135294 A, JP 63-87288 A, JP 4-73392 B, JP 7-100844 B, JP 62-149856 A, JP 4-73394 B, JP 62-181191 A, JP 5-76530 B, JP 63-30294 A, JP 6-37116 B, JP 2-215599 A and JP 61-201747 A.

Aluminum-manganese alloys are mentioned in JP 60-230951 A, JP 1-306288 A, JP 2-293189 A, JP 54-42284 B, JP 4-19290 B, JP 4-19291 B, JP 4-19292 B, JP 61-35995 A, JP 64-51992 A, JP 4-226394 A, US 5,009,722 and US 5,028,276.

Aluminum-manganese-magnesium alloys are mentioned in JP 62-86143 A, JP 3-222796 A, JP 63-60824 B, JP 60-63346 A, JP 60-63347 A, JP 1-293350 A, EP 223,737 B, US 4,818,300 and GB 1,222,777.

Aluminum-zirconium alloys are mentioned in JP 63-15978 B, JP 61-51395 A, JP 63-143234 A and JP 63-143235 A.

Aluminum-magnesium-silicon alloys are mentioned in GB 1,421,710.

The aluminum alloy may be formed into a plate by, for example, the method described below. First, an aluminum alloy melt that has been adjusted to a given alloying ingredient content is subjected to cleaning treatment by an ordinary method, then is cast. Cleaning treatment, which is carried out to remove hydrogen and other unnecessary gases from the melt, typically involves flux treatment; degassing treatment using argon gas, chlorine gas or the like; filtering treatment using, for example, what is referred to as a rigid media filter (e.g., ceramic tube filters, ceramic foam filters), a filter that employs a filter medium such as alumina flakes or alumina balls, or a glass cloth filter; or a combination of degassing treatment and filtering treatment.

Cleaning treatment is preferably carried out to prevent defects due to foreign matter such as nonmetallic inclusions and oxides in the melt, and defects due to dissolved gases in the melt. The filtration of melts is described in, for example, JP 6-57432 A, JP 3-162530 A, JP 5-140659 A, JP 4-231425 A, JP 4-276031 A, JP 5-311261 A, and JP 6-136466 A. The degassing of melts is described in, for example, JP 5-51659 A and JP 5-49148 U. The present applicant also proposes related technology concerning the degassing of melts in JP 7-40017 A.

Next, the melt that has been subjected to cleaning treatment as described above is cast. Casting processes include those which use a stationary mold, such as direct chill casting, and those which use a moving mold, such as continuous casting.
In direct chill casting, the melt is solidified at a cooling speed of 0.5 to 30°C per second. At less than 1°C/s, many coarse intermetallic compounds may be formed. When direct chill casting is carried out, an ingot having a thickness of 300 to 800 mm can be obtained. If necessary, this ingot is scalped by a conventional method, generally removing 1 to 30 mm, and preferably 1 to 10 mm, of material from the surface. The ingot may also be optionally soaked, either before or after scalping. In cases where soaking is carried out, the ingot is heat treated at 450 to 620°C for 1 to 48 hours to prevent the coarsening of intermetallic compounds. The effects of soaking treatment may be inadequate if heat treatment time is shorter than one hour.

The ingot is then hot-rolled and cold-rolled, giving a rolled aluminum plate. A temperature of 350 to 500°C at the start of hot rolling is appropriate. Intermediate annealing may be carried out before or after hot rolling, or even during hot rolling. The intermediate annealing conditions may consist of 2 to 20 hours of heating at 280 to 600°C, and preferably 2 to 10 hours of heating at 350 to 500°C, in a batch-type annealing furnace, or of heating for up to 6 minutes at 400 to 600°C, and preferably up to 2 minutes at 450 to 550°C, in a continuous annealing furnace. Using a continuous annealing furnace to heat the rolled plate at a temperature rise rate of 10 to 200°C/s enables a finer crystal structure to be achieved.

The aluminum plate that has been finished by the above step to a given thickness of, say, 0.1 to 0.5 mm may then be flattened with a leveling machine such as a roller leveler or a tension leveler. Flattening may be carried out after the aluminum plate has been cut into discrete sheets. However, to enhance productivity, it is preferable to carry out such flattening with the rolled aluminum in the state of a continuous coil. The plate may also be passed through a slitter line to cut it to a predetermined width. A thin film of oil may be provided on the surface of the aluminum plate to prevent scuffing due to friction between adjoining aluminum plates. Suitable use may be made of either a volatile or non-volatile oil film, as needed.

Continuous casting processes that are industrially carried out include processes which use cooling rolls, such as the twin roll process (Hunter process) and the 3C process; and processes which use a cooling belt or a cooling block, such as the twin belt process (Hazelett process) and the Alusuisse Caster II process. When a continuous casting process is used, the melt is solidified at a cooling rate of 100 to 1,000°C/s. Continuous casting processes generally have a faster cooling rate than direct chill casting processes, and so are characterized by the ability to achieve a higher solid solubility of alloying ingredients in the aluminum matrix. Technology relating to continuous casting processes that has been proposed by the applicant of the invention is described in, for example, JP 3-79798 A, JP 5-201166 A, JP 5-156414 A, JP 6-262203 A, JP 6-122949 A, JP 6-210406 A and JP 6-26308 A.

When continuous casting is carried out, such as by a process involving the use of cooling rolls (e.g., the Hunter process), the melt can be directly and continuously cast as a plate having a thickness of 1 to 10 mm, thus making it possible to omit the hot rolling step. Moreover, according to a process that employs a cooling belt (e.g., the Hazelett process), a plate having a thickness of 10 to 50 mm can be cast. Generally, by positioning a hot-rolling roll immediately downstream of the casting section, the cast plate can then be successively rolled, enabling a continuously cast and rolled plate with a thickness of 1 to 10 mm to be obtained.

These continuously cast and rolled plates are then subjected to such processes as cold rolling, intermediate annealing, flattening and slitting in the same way as described above for direct chill casting, and thereby finished to a plate thickness of 0.1 to 0.5 mm, for instance. Technology proposed by the applicant of the invention concerning the intermediate annealing conditions and cold rolling conditions in a continuous casting process is described in, for example, JP 6-220593 A, JP 6-210308 A, JP 7-54111 A and JP 8-92709 A.

Because the crystal structure at the surface of the aluminum plate may give rise to a poor surface quality when chemical graining treatment or electrochemical graining treatment is carried out, it is preferable that the crystal structure not be too coarse. The crystal structure at the surface of the aluminum plate has a width of preferably up to 200 $\mu$m, more preferably up to 100 $\mu$m, and most preferably up to 50 $\mu$m. Moreover, the crystal structure has a length of preferably up to 5,000 $\mu$m, more preferably up to 1,000 $\mu$m, and most preferably up to 500 $\mu$m. Related technology proposed by the applicant of the invention is described in, for example, JP 6-218495 A, JP 7-39906 A and JP 7-124609 A.

It is preferable for the alloying ingredient distribution at the surface of the aluminum plate to be reasonably uniform because non-uniform distribution of alloying ingredients at the surface of the aluminum plate sometimes leads to a poor surface quality when chemical graining treatment or electrochemical graining treatment is carried out. Related technology proposed by the applicant of the invention is described in, for example, JP 6-48058 A, JP 5-301478 A and JP 7-132689 A.

The size or density of intermetallic compounds in an aluminum plate may affect chemical graining treatment or electrochemical graining treatment. Related technology proposed by the applicant of the invention is described in, for example, JP 7-138687 A and JP 4-254545 A.

In the invention, the aluminum plate as described above may be used after a textured pattern has been formed on the aluminum plate in the final rolling process or the like by pack rolling, transfer or another method.

The aluminum plate that may be used in the invention may be in the form of an aluminum web or a cut sheet. When the aluminum plate is in the form of a web, it may be packed by, for example, laying hardboard and felt on an iron pallet, placing corrugated cardboard doughnuts on either side of the product, wrapping everything with polytubing, inserting a wooden doughnut into the opening at the center of the coil, stuffing felt around the periphery of the coil, tightening steel strapping about the entire package, and labeling the exterior. In addition, polyethylene film can be used as the outer wrapping material, and needled felt and hardboard can be used as the cushioning material. Various other forms of packing exist, any of which may be used so long as the aluminum plate can be stably transported without being scratched or otherwise marked.

The aluminum plate that may be used in the invention preferably has a thickness of about 0.1 to about 2.0 mm, more preferably 0.15 to 1.5 mm, and even more preferably 0.2 to 1.0 mm. This thickness can be changed as appropriate according to the desires of the user.

3. <Surface Treatment>

The surface treatments performed during the manufacture of the light reflecting substrate of the invention include surface roughening treatment and anodizing treatment. Various other steps than surface roughening treatment and anodizing treatment may also be included in the process of manufacturing the porous alumina support.
Typical methods of forming the surface profile described above include a method in which an aluminum plate is subjected to mechanical graining treatment, alkali etching treatment, desmutting treatment with an acid and electrochemical graining treatment with an electrolytic solution in this order; a method in which an aluminum plate is subjected to mechanical graining treatment, and two or more cycles of alkali etching treatment, desmutting treatment with an acid and electrochemical graining treatment (different electrolytic solutions are used in the respective cycles); a method in which an aluminum plate is subjected to alkali etching treatment, desmutting treatment with an acid, and electrochemical graining treatment with an electrolytic solution in this order; and a method in which an aluminum plate is subjected to two or more cycles of alkali etching treatment, desmutting treatment with an acid and electrochemical graining treatment (different electrolytic solutions are used in the respective cycles). However, the invention is not limited thereto. In these methods, electrochemical graining treatment may be further followed by alkali etching treatment and desmutting treatment with an acid.

Although the method applied depends on the conditions of the other treatments (including alkali etching treatment), a method in which mechanical graining treatment, electrochemical graining treatment using a nitric acid-based electrolytic solution, and electrochemical graining treatment using a hydrochloric acid-based electrolytic solution are performed in this order is preferably used to form a surface profile in which the small-wave structure is superimposed on the medium-wave structure, which in turn is superimposed on the large-wave structure. In order to form a surface profile in which the small-wave structure is superimposed on the large-wave structure, a method is preferably used in which electrochemical graining treatment using a hydrochloric acid-based electrolytic solution is only performed with an increased total amount of electricity furnished to the anodic reaction.

The respective surface treatment steps are described below in detail.

<Mechanical Graining Treatment>

Mechanical graining treatment is less expensive than electrochemical graining and can form a surface having irregularities with an average wavelength of 5 to 100 $\mu$m. It is thus effective as a graining means for forming the large-wave structure.

Examples of mechanical graining treatment include wire brush graining in which the aluminum surface is scratched with metal wire, ball graining in which the aluminum surface is grained with abrasive balls and an abrasive, and brush graining described in JP 6-135175 A and JP 50-40047 B in which the surface is grained with a nylon brush and an abrasive.

It is also possible to use a transfer roll method in which a textured surface is pressed against the aluminum plate. Specific examples of the method that may be employed include the methods described in JP 55-74898 A, JP 60-36195 A and JP 60-203496 A, the method described in JP 6-55871 A which is characterized by carrying out transfer a plurality of times, and the method described in JP 6-24168 A which is **characterized in that** the surface has elasticity.

Other methods that may be used include a method in which transfer is repeatedly carried out using a transfer roll in which a fine texture has been formed by, for example, electrodischarge machining, shot blasting, laser machining or plasma etching; and a method in which a textured surface coated with fine particles is placed against the aluminum plate, pressure is repeatedly applied from above the textured surface a plurality of times, and a textured pattern corresponding to the average diameter of the fine particles is repeatedly transferred to the aluminum plate. Know methods such as those described in JP 3-8635 A, JP 3-66404 A and JP 63-65017 A may be used to impart a fine texture to the transfer roll. Alternatively, an angular texture may be applied to the roll surface by forming fine grooves in the roll surface in two directions with, for example, a die, a cutting tool or a laser. The resulting roll surface may be subjected to a known etching treatment to round somewhat the angular texture thus formed.

A process such as quenching or hard chromium plating may also be carried out to increase the surface hardness.

In addition, use may also be made of the mechanical graining treatments described in, for example, JP 61-162351 A and JP 63-104889 A.

In the practice of the invention, the methods mentioned above may be used in combination while taking into account productivity and other factors. It is preferable for these mechanical graining treatments to be carried out prior to electrochemical graining treatment.

The brush graining process, which may be suitably used as the mechanical graining treatment, is described below in detail. The brush graining process is generally a method in which a brush roller composed of a round cylinder on the surface of which are set numerous bristles, typically made of a synthetic resin such as nylon(trademark), polypropylene or polyvinyl chloride is used to rub one or both sides of the aluminum plate while an abrasive-containing slurry is sprayed onto the rotating brush roller. A polishing roller having a polishing layer formed on its surface may be used instead of the aforementioned brush roller and slurry. When a brush roller is used, the bristles on the brush have a flexural modulus of preferably 10,000 to 40,000 kgf/cm$^2$, and more preferably 15,000 to 35,000 kgf/cm$^2$, and a stiffness of preferably 500 gf or less, and more preferably 400 gf or less. The bristle diameter is generally 0.2 to 0.9 mm. The bristle length can be suitably selected in accordance with the outside diameter of the brush roller and the cylinder diameter, but is generally from 10 to 100 mm.

A known abrasive may be used. Illustrative examples include pumice stone, silica sand, aluminum hydroxide, alumina powder, silicon carbide, silicon nitride, volcanic ash, carborundum, emery, and mixtures thereof. Of these, pumice stone and silica sand are preferred. Silica sand is especially preferred because it is harder than pumice stone and breaks less readily, and thus has an excellent graining efficiency. To provide an excellent graining efficiency and reduce the pitch of the grained pattern, it is desirable for the abrasive to have an average particle size of preferably 3 to 50 $\mu$m, and more preferably 6 to 45 $\mu$m. The abrasive is typically suspended in water and used as a slurry. In addition to the abrasive, the slurry may also include such additives as a thickener, a dispersant (e.g., a surfactant), and a preservative. The slurry has a specific gravity in a range of preferably 0.5 to 2.

An example of an apparatus suitable for mechanical graining treatment is that described in JP 50-40047 B.

<Electrochemical Graining Treatment>

Electrochemical graining treatment (also referred to below as "electrolytic graining treatment") may be carried out with an electrolytic solution of the type employed in conventional electrochemical graining treatment using an alternating current. In particular, the use of an electrolytic solution containing primarily hydrochloric acid or nitric acid enables the surface profile as described above to be readily obtained and is therefore preferable.

Electrolytic graining treatment may be carried out in accordance with, for example, the electrochemical graining process (electrolytic graining process) described in JP 48-28123 B and GB 896,563. A sinusoidal alternating current is used in the electrolytic graining process but special waveforms described in JP 52-58602 A may also be used. Use may also be made of the waveforms described in JP 3-79799 A. Other processes that may be employed for this purpose include those described in JP 55-158298 A, JP 56-28898 A, JP 52-58602 A, JP 52-152302 A, JP 54-85802 A, JP 60-190392 A, JP 58-120531 A, JP 63-176187 A, JP 1-5889 A, JP 1-280590 A, JP 1-118489 A, JP 1-148592 A, JP 1-178496 A, JP 1-188315 A, JP 1-154797 A, JP 2-235794 A, JP 3-260100 A, JP 3-253600 A, JP 4-72079 A, JP 4-72098 A, JP 3-267400 A and JP 1-141094 A. In addition to the above, electrolytic graining treatment may also be carried out using alternating currents of special frequency such as have been proposed in connection with methods for manufacturing electrolytic capacitors. These are described in, for example, US 4,276,129 and US 9,676,879.

Various electrolytic cells and power supplies have been proposed. For example, use may be made of those described in US 4,203,637, JP 56-123400 A, JP 57-59770 A, JP 53-12738 A, JP 53-32821 A, JP 53-32822 A, JP 53-32823 A, JP 55-122896 A, JP 55-132884 A, JP 62-127500 A, JP 1-52100 A, JP 1-52098 A, JP 60-67700 A, JP 1-230800 A, JP 3-257199 A, JP 52-58602 A, JP 52-152302 A, JP 53-12738 A, JP 53-12739 A, JP 53-32821 A, JP 53-32822 A, JP 53-32833 A, JP 53-32824 A, JP 53-32825 A, JP 54-85802 A, JP 55-122896 A, JP 55-132884 A, JP 48-28123 B, JP 51-7081 B, JP 52-133838 A, JP 52-133840 A, JP 52-133844 A, JP 52-133845 A, JP 53-149135 A and JP 54-146234 A.

In addition to nitric acid and hydrochloric acid solutions, other acidic solutions that may be used for the electrolytic solution include the electrolytic solutions mentioned in US 4,671,859, US 4,661,219, US 4,618,405, US 4, 600, 482, US 4,566,960, US 4,566,958, US 4,566,959, US 4,416,972, US 4,374,710, US 4,336,113 and US 4,184,932.

The acidic solution has a concentration of preferably 0.5 to 2.5 wt%, although a concentration of 0.7 to 2.0 wt% is especially preferred for use in desmutting treatment mentioned above. The electrolytic solution preferably has a temperature of 20 to 80°C and more preferably 30 to 60°C.

The aqueous solution composed primarily of hydrochloric acid or nitric acid may be obtained by dissolving a nitrate ion-containing compound such as aluminum nitrate, sodium nitrate or ammonium nitrate or a chloride ion-containing compound such as aluminum chloride, sodium chloride or ammonium chloride to a concentration of from 1 g/L to saturation in a 1 to 100 g/L solution of hydrochloric acid or nitric acid in water. Metals which are present in the aluminum alloy, such as iron, copper, manganese, nickel, titanium, magnesium and silicon may be dissolved in the aqueous solution composed primarily of hydrochloric acid or nitric acid. It is preferable to use a solution prepared by dissolving a compound such as aluminum chloride or aluminum nitrate to an aluminum ion concentration of 3 to 50 g/L in a 0.5 to 2 wt% solution of hydrochloric acid or nitric acid in water.

By adding and using a compound capable of forming a complex with copper, uniform graining may be carried out even on an aluminum plate having a high copper content. Examples of the compound capable of forming a complex with copper include ammonia; amines obtained by substituting the hydrogen atom on ammonia with a hydrocarbon group (of an aliphatic, aromatic, or other nature), such as methylamine, ethylamine, dimethylamine, diethylamine, trimethylamine, cyclohexylamine, triethanolamine, triisopropanolamine and ethylenediamine tetraacetate (EDTA); and metal carbonates such as sodium carbonate, potassium carbonate and potassium hydrogen carbonate. Additional compounds suitable for this purpose include ammonium salts such as ammonium nitrate, ammonium chloride, ammonium sulfate, ammonium phosphate and ammonium carbonate. The temperature of the aqueous solution is preferably in a range of 10 to 60°C and more preferably 20 to 50°C.

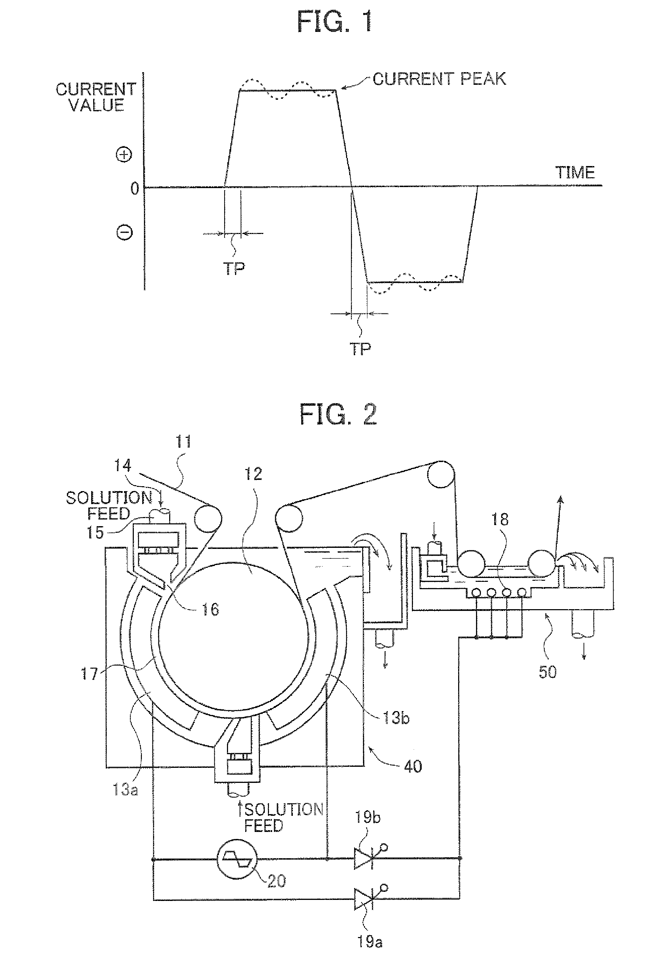

No particular limitation is imposed on the alternating current waveform used in electrochemical graining treatment. For example, a sinusoidal, square, trapezoidal or triangular waveform may be used, but a square or trapezoidal waveform is preferred and a trapezoidal waveform is particularly preferred. "trapezoidal waveform" refers herein to such a waveform as shown in FIG. 1. In the trapezoidal waveform, the time TP in which the current value changes from zero to a peak is preferably 1 to 3 ms. If the time is less than 1 ms, treatment unevenness called "chatter mark" may readily occur perpendicularly to the direction of movement of the aluminum plate. If the time TP exceeds 3 ms, especially when a nitric acid electrolytic solution is used, the process tends to be affected by trace ingredients in the electrolytic solution as typified by ammonium ions that spontaneously increase during electrolytic treatment, making it difficult to carry out uniform graining.

Alternating current having a trapezoidal waveform and a duty ratio of 1:2 to 2:1 may be used. However, as noted in JP 5-195300 A, in an indirect power feed system that does not use a conductor roll to feed current to the aluminum, a duty ratio of 1:1 is preferred. Alternating current having a trapezoidal waveform and a frequency of 0.1 to 120 Hz may be used, although a frequency of 50 to 70 Hz is preferable from the standpoint of the equipment. At a frequency lower than 50 Hz, the carbon electrode serving as the main electrode tends to dissolve more readily. On the other hand, at a frequency higher than 70 Hz, the power supply circuit is more readily subject to the influence of inductance thereon. The result in both of these cases is an increase in the power supply costs.

One or more AC power supplies may be connected to the electrolytic cell. To control the anode/cathode current ratio of the alternating current applied to the aluminum plate opposite to the main electrodes and thereby carry out uniform graining and to dissolve carbon from the main electrodes, it is advantageous to provide auxiliary anodes 18 and divert part of the alternating current as shown in FIG. 2. FIG. 2 shows an aluminum plate 11, a radial drum roller 12, main electrodes 13a and 13b, an electrolytic treatment solution 14, a solution feed inlet 15, a slit 16, a solution channel 17, auxiliary anodes 18, thyristors 19a and 19b, an AC power supply 20, a main electrolytic cell 40 and an auxiliary anode cell 50. By using a rectifying or switching device to divert part of the current as direct current to the auxiliary anodes provided in the separate cell from that containing the two main electrodes, it is possible to control the ratio between the current value furnished to the anodic reaction which acts on the aluminum plate opposite to the main electrodes and the current value furnished to the cathodic reaction. The ratio between the amount of electricity furnished to the cathodic reaction and the amount of electricity furnished to the anodic reaction on the aluminum plate opposite to the main electrodes (ratio of the amount of electricity when the aluminum plate serves as an cathode to that when the aluminum plate serves as an anode) is preferably 0.3 to 0. 95.

Any known electrolytic cell employed for surface treatment, including vertical, flat and radial type electrolytic cells, may be used to carry out electrochemical graining treatment. Radial-type electrolytic cells such as those described in JP 5-195300 A are especially preferred. The electrolytic solution is passed through the electrolytic cell either parallel or counter to the direction in which the aluminum web advances.

(Nitric acid electrolysis)

Irregularities having an average wavelength of 0.5 to $\mu$m can be formed by electrochemical graining treatment using an electrolytic solution composed primarily of nitric acid. When the amount of electricity is made relatively large, the electrolytic reaction concentrates, resulting in the formation of irregularities having a wavelength larger than 5 $\mu$m as well.

To obtain such a surface profile, the total amount of electricity furnished to the anodic reaction on the aluminum plate up until completion of the electrolytic reaction is preferably 1 to 1,000 $C/dm^2$, and more preferably 50 to 300 $C/dm^2$. The current density at this time is preferably 20 to 100 $A/dm^2$.

A small-wave structure having an average wavelength of 0.20 $\mu$m or less may also be formed by performing electrolysis at a temperature of 30 to 60°C with a high-concentration electrolytic solution of nitric acid having a nitric acid concentration of 15 to 35 wt%, or by performing electrolysis at a high temperature (e.g., 80°C or higher) with an electrolytic solution of nitric acid having a nitric acid concentration of 0.7 to 2 wt%. As a result, $\Delta S$ can have a larger value.

(Hydrochloric acid electrolysis)

Hydrochloric acid by itself has a strong ability to dissolve aluminum, and fine irregularities can be formed on the surface with the application of just a slight degree of electrolysis. These fine irregularities have an average wavelength of 0.01 to 0.2 $\mu$m, and arise uniformly over the entire surface of the aluminum plate.

To obtain such a surface profile, the total amount of electricity furnished to the anodic reaction on the aluminum plate up until completion of the electrolytic reaction is preferably 1 to 100 $C/dm^2$ and more preferably 20 to 70 $C/dm^2$. The current density at this time is preferably 20 to 50 $A/dm^2$.

In such electrochemical graining treatment with an electrolytic solution composed primarily of hydrochloric acid, by furnishing a large total amount of electricity of 400 to 2,000 $C/dm^2$ to the anodic reaction, large crater-like undulations can also be formed at the same time. Under these conditions, fine irregularities having an average wavelength of 0.01 to 0.4 $\mu$m are formed on the entire surface so that they are superimposed on crater-like undulations having an average wavelength of 10 to 30 $\mu$m. In this case, the medium-wave structure having an average wavelength of 0.5 to 5 $\mu$m is not formed.

It is effective to form a multiplicity of small irregularities at the surface in order to have a larger $\Delta S$ value. Methods that may be appropriately used to form a multiplicity of small irregularities at the surface as described above include electrolytic graining treatment using an electrolytic solution composed primarily of hydrochloric acid, and electrolytic graining treatment using a high-concentration and high-temperature electrolytic solution composed primarily of nitric acid. The difference in surface area ΔS may take a large value through mechanical graining treatment or commonly performed electrolytic graining treatment using an electrolytic solution composed primarily of nitric acid, but is only increased to a smaller degree than in the above methods.

It is preferable for the aluminum plate to be subjected to cathodic electrolysis before and/or after electrolytic graining treatment in the nitric acid- or hydrochloric acid-containing electrolytic solution as described above. Such cathodic electrolysis gives rise to smut formation on the surface of the aluminum plate and hydrogen gas evolution, which enables more uniform electrolytic graining treatment to be achieved.

Cathodic electrolysis is carried out in an acidic solution in an amount of electricity applied to the cathode of preferably 3 to 80 $C/dm^2$, and more preferably 5 to 30 $C/dm^2$. At less than 3 $C/dm^2$ of electricity, the amount of smut deposition may be inadequate, whereas at more than 80 $C/dm^2$, the amount of smut deposition may be excessive. The electrolytic solution may be the same as or different from the one used in electrolytic graining treatment.

<Alkali Etching Treatment>

Alkali etching is a treatment in which the surface layer of the above-described aluminum plate is brought into contact with an alkali solution and dissolved.

When mechanical graining treatment has not been carried out, the purpose of carrying out alkali etching treatment prior to electrolytic graining treatment is to remove substances such as rolling oils, contaminants and a natural oxide film from the surface of the aluminum plate (rolled aluminum). When mechanical graining treatment has already been carried out, the purpose of such alkali etching treatment is to dissolve the edge areas of pits formed by mechanical graining treatment so as to transform the surface having the pits with sharp edges into a smoothly undulating surface.

If mechanical graining treatment is not carried out prior to alkali etching treatment, the amount of etching is preferably 0.1 to 10 $g/m^2$, and more preferably 1 to 5 $g/m^2$. At less than 0.1 $g/m^2$, substances such as rolling oils, contaminants and a natural oxide film may remain on the surface, which may make it impossible for uniform pits to be formed in subsequent electrolytic graining treatment, and may thus give rise to surface unevenness. On the other hand, at an etching amount of 1 to 10 $g/m^2$, the sufficient removal of substances such as rolling oils, contaminants and a natural oxide film will take place. An etching amount exceeding the above range is economically undesirable.

If mechanical graining treatment is carried out prior to alkali etching treatment, the amount of etching is preferably 3 to 20 $g/m^2$, and more preferably 5 to 15 $g/m^2$. At an etching amount of less than 3 $g/m^2$, it may not be possible to smoothen the irregularities formed by treatment such as mechanical graining treatment, as a result of which uniform pit formation may be impossible to achieve in subsequent electrolytic graining treatment. On the other hand, at an etching amount of more than 20 $g/m^2$, the textured surface structure may vanish.

The purpose of carrying out alkali etching treatment immediately after electrolytic graining treatment is to dissolve smut that has formed in the acidic electrolytic solution and to dissolve the edge areas of pits that have been formed by electrolytic graining treatment. The pits that are formed by electrolytic graining treatment vary depending on the type of electrolytic solution used, so the optimal amount of etching also varies. However, the amount of etching in alkali etching treatment carried out after electrolytic graining treatment is preferably 0.1 to 5 $g/m^2$. When a nitric acid electrolytic solution is used, it is necessary to set the amount of etching somewhat larger than that when a hydrochloric acid electrolytic solution is used. If electrolytic graining treatment is carried out a plurality of times, alkali etching may be carried out as needed after each electrolytic graining treatment.

Alkalis that may be used in the aqueous alkali solution are exemplified by caustic alkalis and alkali metal salts. Specific examples of suitable caustic alkalis include sodium hydroxide and potassium hydroxide. Specific examples of suitable alkali metal salts include alkali metal silicates such as sodium metasilicate, sodium silicate, potassium metasilicate and potassium silicate; alkali metal carbonates such as sodium carbonate and potassium carbonate; alkali metal aluminates such as sodium aluminate and potassium aluminate; alkali metal aldonates such as sodium gluconate and potassium gluconate; and alkali metal hydrogenphosphates such as sodium secondary phosphate, potassium secondary phosphate, sodium tertiary phosphate and potassium tertiary phosphate. Of these, caustic alkali solutions and solutions containing both a caustic alkali and an alkali metal aluminate are preferred on account of the high etch rate and low cost. An aqueous solution of sodium hydroxide is especially preferred.

The concentration of the alkali solution may be set in accordance with the desired amount of etching, and is preferably 1 to 50 wt%, and more preferably 10 to 35 wt%. When aluminum ions are dissolved in the alkali solution, the concentration of the aluminum ions is preferably 0.01 to 10 wt%, and more preferably 3 to 8 wt%. The alkali solution preferably has a temperature of 20 to 90°C. The treatment time is preferably from 1 to 120 seconds.

Illustrative examples of methods for bringing the aluminum plate into contact with the alkali solution include a method in which the aluminum plate is passed through a tank filled with an alkali solution, a method in which the aluminum plate is immersed in a tank filled with an alkali solution, and a method in which the surface of the aluminum plate is sprayed with an alkali solution.

<Desmutting Treatment>

After electrolytic graining treatment or alkali etching treatment, it is preferable to carry out acid pickling (desmutting treatment) to remove contaminants (smut) remaining on the surface of the aluminum plate. Examples of acids that may be used include nitric acid, sulfuric acid, phosphoric acid, chromic acid, hydrofluoric acid and tetrafluoroboric acid. Desmutting treatment is carried out by bringing the aluminum plate into contact with an acidic solution of, for example, hydrochloric acid, nitric acid or sulfuric acid having an acid concentration of 0.5 to 30 wt% and an aluminum ion concentration of 0.01 to 5 wt%. Exemplary methods for bringing the aluminum plate into contact with the acidic solution include passing the aluminum plate through a tank filled with the acidic solution, immersing the aluminum plate in a tank filled with the acidic solution, and spraying the acidic solution onto the surface of the aluminum plate. The acidic solution used in desmutting treatment may be the aqueous solution composed primarily of nitric acid or the aqueous solution composed primarily of hydrochloric acid that is discharged as wastewater from the above-described electrolytic graining treatment, or the aqueous solution composed primarily of sulfuric acid that is discharged as wastewater from the subsequently described anodizing treatment. The solution temperature in desmutting treatment is preferably 25 to 90°C. The treatment time is preferably from 1 to 180 seconds. The acidic solution used in desmutting treatment may include aluminum and aluminum alloy components dissolved therein.

4. <Through-hole formation and routing>

In the light reflecting substrate of the invention, through-hole formation for appropriately providing an interconnect portion and routing for a system on a chip assuming a final product (processing for individuating the final product) may also be performed prior to mounting the light-emitting device. Through-hole formation may be preceded or followed by anodizing treatment step. Such processing before the formation of the insulating layer through anodization to be described later can prevent the insulating layer formed by anodization from being cracked while holding the insulating properties of the end surfaces of the substrate formed by the processing. When performed after the anodizing treatment step, through-hole formation increases the efficiency of the anodizing treatment step and the anodized film can be precisely processed to a size of the final product.

Through-hole formation is boring the plate in necessary portions. However, the shape of the through-holes formed is not particularly limited if they have a length that may reach a plurality of layers to be interconnected and their cross-section has a size and a shape that can ensure necessary interconnection. In consideration of the final chip size and reliable interconnect formation, the shape is preferably circular, and the size in terms of the through-hole diameter is preferably 0.01 mm to 2 mm, more preferably 0.05 to 1 mm and most preferably 0.1 mm to 0.8 mm.

As shown in FIG. 11(A1) to (A4), routing is cutting the plate into individual segments each having a size of a light reflecting substrate (hereinafter referred to as "chip") individuated as a final product and is also called patterning or chipping. This size includes a machining allowance necessary for the final product or the necessary size is preliminarily determined in consideration of the volume expansion due to anodization. Routing may be preceded or followed by anodizing treatment step. Such processing before the formation of the insulating layer through anodization to be described later can prevent the insulating layer formed by anodization from being cracked while holding the insulating properties of the end surfaces of the substrate formed by the processing. When performed after the anodizing treatment step, routing increases the efficiency of the anodizing treatment step and the anodized film can be precisely processed to a size of the final product.

It is necessary to consider the size/shape of the final chip for the routing, but when a square chip is assumed, the length of one side is preferably in the range of 0.1 mm to 50 mm, more preferably in the range of 0.2 mm to 40 mm, and particularly preferably in the range of 0.4 mm to 30 mm, from the viewpoints of compactness of a chip and processing suitability. Particularly, when a light reflecting substrate for a main package is assumed, the routing is preferably performed in a size of 3.2 mm×2.8 mm, 1.6 mm×0.8 mm, which is the current shape and size example, or the like.

A device mounting portion (not shown, a portion on which a device is mounted later) after the routing is preferably processed in a shape for achieving electrical connection to a device portion (not shown, a portion electrically connected to a device) so as to form an insulating layer by anodizing treatment to be described later. Preferred examples thereof include a method of performing a routing process in a state where an electrical connection portion is formed and a method of connecting the device portion through the use of a conductive wire or the like, but the method is not limited to the examples.

Examples of the method suitable to the through-hole formation and routing include drilling, press working using a die, dicing using a dicing saw and laser processing but the method is not limited thereto.

<Method of insulating metal-aluminum-exposed portion which has shape in which portions corresponding to individual chips are connected with joint portions before being cut by routing process and can be disposed in thickness direction of individual chips after being cut into individual chips at joint portions>

The routing process is not limited, but for example, by cutting cutout portions 43 surrounding a portion of a chip 41 serving as an individual light reflecting substrate shown in FIG. 11(A2) up to the bottom of the aluminum plate 1, which is the aluminum plate 1 as a metal plate shown in FIG. 11(A1), but leaving joint portions 42 connecting the chips or the chips and the aluminum plate 1 at that time, the chips 41 are not scattered but are treated in a body as the aluminum plate, which is very suitable. Thereafter, necessary treatment such as the anodizing treatment is performed as shown in FIG. 11(A3) and then the joint portions 42 are cut to obtain individual chips 41 as shown in FIG. 11(A4). However, since non-anodized metal aluminum is exposed from the cut edge 45 of the joint portion 42 on the side surface of each cut chip, the insulation performance of the side surfaces of the obtained individual chips 41 is not sufficient. To prevent this problem, in the routing of the invention, the portion serving as the joint portion 42 is preliminarily designed to be thinner than the portion serving as the chip 41 in the state of the aluminum plate 1 as a metal plate as shown in the left sectional views of FIGS. 11(B1) and 11(B2). Preferably, the thickness of the joint portion is preliminarily designed to be not more than twice the thickness of an oxide film formed by the anodizing. When it is intended to design the portion serving as the joint portion to be thinner or to be not more than double the thickness of the oxide film formed by the anodizing, various processing methods such as the routing can be employed. When the portion serving as the joint portion 42 is designed to be thin, the insulating film which is an anodized film can be anodized so as to occupy most of the thickness of the joint portion after the anodizing treatment, as shown in the central section of FIGS. 11(B1) and 11 (B2). For example, as shown in the central side of FIG. 11(B1), the aluminum portion of the cut edge 45 has a very small thickness. As shown in the central side of FIG. 11(B2), most the joint portion in the thickness direction thereof is anodized. By cutting this joint portion, as shown in the right sides of FIGS. 11(B1) and 11(B2), it is possible to obtain individual chips 41 in which the non-anodized portion of the cut edge 45 of each individual chip is very small [the right side of FIG. 11(B1)] or is not left at all [the right side of FIG. 11(B2)].

5. <Anodizing Treatment>

The aluminum plate having undergone the foregoing surface treatments and processing is further anodized. As a result of anodizing treatment, an anodized alumina film is formed at a surface of the aluminum plate, whereby a porous or non-porous surface insulating layer is obtained.

Anodizing treatment can be carried out by a commonly used method. More specifically, an anodized layer can be formed on the surface of the aluminum plate by passing a current through the aluminum plate as the anode in, for example, a solution having a sulfuric acid concentration of 50 to 300 g/L and an aluminum ion concentration of up to 5 wt%. The solution that may be used in anodizing treatment may contain acids such as sulfuric acid, phosphoric acid, chromic acid, oxalic acid, sulfamic acid, benzenesulfonic acid, amidosulfonic acid, masonic acid, citric acid, tartaric acid and boric acid. The acids may be used singly or in combination of two or more.

It is acceptable for ingredients ordinarily present in at least the aluminum plate, electrodes, tap water, ground water and the like to be present in the electrolytic solution. In addition, secondary and tertiary ingredients may be added. Here, "secondary and tertiary ingredients" includes, for example, the ions of metals such as sodium, potassium, magnesium, lithium, calcium, titanium, aluminum, vanadium, chromium, manganese, iron, cobalt, nickel, copper and zinc; cations such as ammonium ion; and anions such as nitrate ion, carbonate ion, chloride ion, phosphate ion, fluoride ion, sulfite ion, titanate ion, silicate ion and borate ion. These may be present in concentrations of about 0 to 10,000 ppm.

The anodizing treatment conditions vary depending on the electrolytic solution used, and thus cannot be strictly specified. However, it is generally suitable for the solution to have an electrolyte concentration of 1 to 80 wt% and a temperature of 5 to 70°C, and for the current density to be 0.5 to 60 A/dm2, the voltage to be 1 to 100 V, and the electrolysis time to be 15 seconds to 50 minutes. These conditions may be adjusted to obtain the desired anodized layer weight.

Methods that may be used to carry out anodizing treatment include those described in JP 54-81133 A, JP 57-47894 A, JP 57-51289 A, JP 57-51290 A, JP 57-54300 A, JP 57-136596 A, JP 58-107498 A, JP 60-200256 A, JP 62-136596 A, JP 63-176494 A, JP 4-176897 A, JP 4-280997 A, JP 6-207299 A, JP 5-24377 A, JP 5-32083 A, JP 5-125597 A and JP 5-195291 A.

Of these, as described in JP 54-12853 A and JP 48-45303 A, it is preferable to use an aqueous sulfuric acid solution as the electrolytic solution. The electrolytic solution has a sulfuric acid concentration of preferably 10 to 300 g/L, and an aluminum ion concentration of preferably 1 to 25 g/L and more preferably 2 to 10 g/L. Such an electrolytic solution can be prepared by adding a compound such as aluminum sulfate to dilute sulfuric acid having a sulfuric acid concentration of 50 to 200 g/L.

When anodizing treatment is carried out in an electrolytic solution containing sulfuric acid, direct current or alternating current may be applied across the aluminum plate and the counter electrode. When a direct current is applied to the aluminum plate, the current density is preferably 1 to 60 $A/dm^2$ and more preferably 5 to 40 $A/dm^2$. To keep burnt deposits from arising on portions of the aluminum plate due to the concentration of current when anodizing treatment is carried out as a continuous process, it is preferable to apply current at a low density of 5 to 10 $A/dm^2$ at the start of anodizing treatment and to increase the current density to 30 to 50 $A/dm^2$ or more as anodizing treatment proceeds. When anodizing treatment is carried out as a continuous process, this is preferably done using a system that supplies power to the aluminum plate through the electrolytic solution.

When the anodized film is porous, the average pore size is about 5 nm to about 1,000 nm and the average pore density is $1 \times 10^6$ pcs/$mm^2$ to about $1 \times 10^{10}$ pcs/$mm^2$.

The thickness of the anodized film is preferably 1 to 200 $\mu$m. A film thickness of less than 1 $\mu$m reduces the withstand voltage due to poor insulating properties, whereas a film thickness in excess of 200 $\mu$m requires a large amount of electrical power, which is economically disadvantageous. The thickness of the anodized film is preferably 2 to 100 $\mu$m.

Examples of electrolysis apparatuses that may be used in anodizing treatment include those described in JP 48-26638 A, JP 47-18739 A and JP 58-24517 B. Of these, an apparatus like that shown in FIG. 3 is preferred. FIG. 3 is a schematic view showing an exemplary apparatus for anodizing the surface of an aluminum plate. In an anodizing apparatus 410, an aluminum plate 416 is transported as shown by arrows in FIG. 3. The aluminum plate 416 is charged positive (+) by a power supply electrode 420 in a power supply cell 412 containing an electrolytic solution 418. The aluminum plate 416 is then transported upward by a roller 422 disposed in the power supply cell 412, turned downward by a nip roller 424 and transported toward an electrolytic cell 414 containing an electrolytic solution 426 to be turned to a horizontal direction by a roller 428. Then, the aluminum plate 416 is charged negative (-) by an electrolytic electrode 430 to form an anodized layer on the plate surface. The aluminum plate 416 emerging from the electrolytic cell 414 is then transported to the section for the subsequent step. In the anodizing apparatus 410, the roller 422, the nip roller 424 and the roller 428 constitute direction changing means, and the aluminum plate 416 is transported through the power supply cell 412 and the electrolytic cell 414 in a mountain shape and a reversed U shape by means of these rollers 422, 424 and 428. The power supply electrode 420 and the electrolytic electrode 430 are connected to a dc power supply 434.

The characteristic feature of the anodizing apparatus 410 shown in FIG. 3 is that the aluminum plate 416 is transported in a mountain shape and a reversed U shape through the power supply cell 412 and the electrolytic cell 414 that are separated by a single cell wall 432. This configuration enables the length of the aluminum plate 416 held in the two cells to be the shortest. Therefore, the total length of the anodizing apparatus 410 can be shortened, thus enabling a decrease in equipment costs. Transport of the aluminum plate 416 in a mountain shape and a reversed U shape eliminates the necessity of forming an opening for passing the aluminum plate 416 through the cell wall 432 between the cells 412 and 414. The amount of electrolytic solution required for maintaining each of the liquid surfaces of the cells 412 and 414 at a necessary height can be thus suppressed to enable a decrease in running costs.

<Sealing Treatment>

In the practice of the invention, if necessary, sealing treatment may be performed to close the micropores present in the porous anodized film. Sealing treatment may be performed in accordance with a known method, such as boiling water treatment, hot water treatment, steam treatment, sodium silicate treatment, nitrite treatment or ammonium acetate treatment. Sealing treatment may be carried out by using the apparatuses and methods described in, for example, JP 56-12518 B, JP 4-4194 A, JP 5-202496 A and JP 5-179482 A.

<Rinsing Treatment>

Each of the aforementioned treatment steps is preferably followed by rinsing with water. Water that may be used in rinsing includes pure water, ground water and tap water. A nipping device may also be used to prevent the treatment solution to be carried over to the next step.

6. <Other>

In addition, various processes may be performed on the surface of the light reflecting substrate of the invention, if necessary.
For example, an inorganic insulating layer formed of a white insulating material such as titanium oxide and an organic insulating layer formed of a white resist or the like may be formed to enhance the whiteness of the reflecting substrate. The insulating layer formed of alumina can be colored with a desired color other than white, for example, through the use of electrodeposition. Specifically, color-stainable ion species described in "Anodizing" published by Metal Finishing Society of Japan, Metal Finishing Course B (1969 PP. 195~207), "New Alumite Theory" published by KALLOS PUBLISHING Co., Ltd. (1997 pp. 95-96), and the like, such as Co ions, Fe ions, Au ions, Pb ions, Ag ions, Se ions, Sn ions, Ni ions, Cu ions, Bi ions, Mo ions, Sb ions, Cd ions, and/or As ions, are mixed into an electrolyte and electrolysis treatment is performed thereon, whereby the coloring is achieved.

To further enhancing the insulation performance and the reflectivity, a layer based on a sol-gel method may be similarly formed on the insulating layer formed of alumina, for example, as described in paragraphs [0016] to [0035] in JP 6-35174 A. A sol-gel method is a method of changing a sol formed of metal alkoxide to a gel without fluidity through the use of hydrolysis and polycondensation reactions and heating the gel to form an oxide layer (a ceramic layer).

The metal alkoxide used in the invention is not particularly limited, but to form a layer with a uniform thickness, examples thereof include Al(O-R)n, Ba(O-R)n, B(O-R)n. Bi(O-R)n, Ca(O-R)n, Fe(O-R)n, Ga(O-R)n, Ge(O-R)n, Hf(O-R)n, In(O-R)n, K(O-R)n, La(OR)n, Li(O-R)n, Mg(O-R)n, Mo(O-R)n, Na(O-R)n, Nb(O-R)n, Pb(O-R)n, Po(O-R)n, Po(O-R)n, P(O-R)n, Sb(O-R)n, Si(O-R)n, Sn(O-R)n, Sr(OR)n, Ta(O-R)n, Ti(O-R)n, V(O-R)n, W(O-R)n, Y(O-R)n, Zn(O-R)n, and Zr(O-R)n (where R represents a chained, branched, or cyclic hydrocarbon group which may have a substituent group and n represents a natural number). Among these, in a preferable aspect of the invention, since the insulating layer is an aluminum-anodized layer, Si(O-R)n is more preferable, which is excellent in reactivity with alumina and excellent in sol-gel layer formability.

The method of forming a sol-gel layer is not particularly limited, but to control the thickness of the layer, a method of applying and heating a sol liquid can be preferably used. The concentration of the sol liquid is preferably in the range of 0.1 to 90 wt%, more preferably in the range of 1 to 80 wt%, and particularly preferably in the range of 5 to 70 wt%. The sol liquid may be repeatedly applied to thicken the layer.

To form the sol-gel layer in the invention, the thickness thereof is preferably in the range of 0.01 $\mu$m to 20 $\mu$m, more preferably in the range of 0.05 $\mu$m to 15 $\mu$m, and particularly preferably in the range of 0.1 $\mu$m to 10 $\mu$m, from the viewpoints of high reflectivity and insulation performance. When the thickness is larger than this range, it is not desirable from the viewpoint of high reflectivity. When the thickness is smaller than this range, it is not desirable from the viewpoint of insulation performance.

7. <Use of Light Reflecting Substrate>

The light reflecting substrate of the invention is not particularly limited in the type of an LED used, the shape of a light-emitting device, or the like, and can be used for various applications. The light reflecting substrate of the invention can be also used as a light reflecting substrate of a light-emitting device employing a known LED.

For example, by using the light reflecting substrate 30 of the invention instead of the substrate 140 shown in FIG. 5, it is possible to improve the brightness of the light-emitting unit 100.

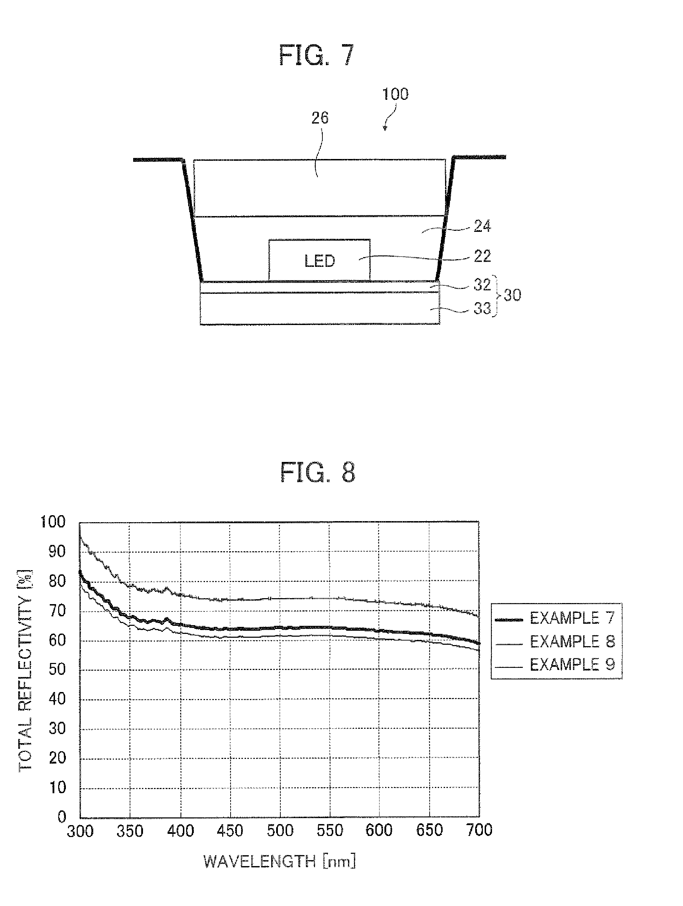

As shown in FIG. 7, the fluorescent light-emitting device having the configuration in which a blue LED 22 is disposed on the light reflecting substrate 30 including the insulating layer 32 and the metal layer 33, the resultant is sealed with a known resin 24, and a micro structure 26 (fluorescent light-emitting unit) which is an anodized layer of a valve metal having a fluorescent emitter is disposed thereon may be used. This fluorescent light-emitting device is described in Japanese Patent Application Nos. 2009-134007 and 2009-139261.

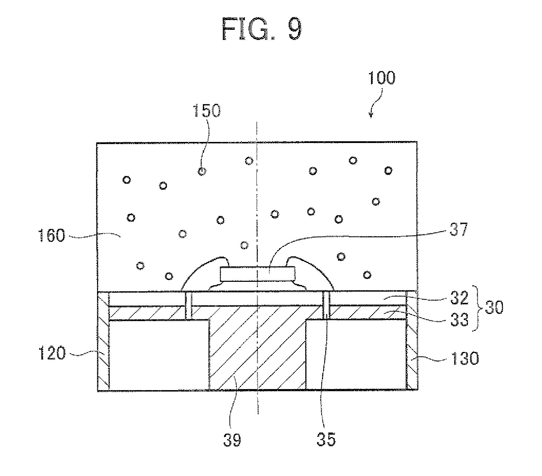

FIG. 9 is a sectional view showing a fluorescent light-emitting unit 100 in which a device 37 such as a light-emitting diode placed on the light reflecting substrate 30 of the invention including the insulating layer 32 and the metal layer 33 formed in contact therewith is sealed with the transparent resin 160 containing the fluorescent particles 150. The device 37 is placed on the light reflecting substrate 30 by die bonding or the like, a through-hole 35 is formed in the light reflecting substrate 30, and the metal layer 33 located below the device 37 may be formed in a shape having a larger thickness than that of the other substrate portion to serve as a heat sink 39. Preferably, the insulating layer 32 is an anodized film of the aluminum metal layer 33 and the inside of the through-hole is anodized to form an insulating layer. The device 37 is electrically connected to external electrodes 120 and 130 through the use of wire bonding. Since the light reflecting substrate 30 of the invention is high in the total reflectivity at a specific wavelength, the brightness of the fluorescent light-emitting unit 100 using the light reflecting substrate as a substrate is high.

The light-emitting diode device 37 which includes a light-emitting layer of a semiconductor such as GAMIN, ZnS, ZnSe, SiC, GaP, GaAlAs, AIN, InN, AlInCaP, InGaN, GaN or AlInGaN formed on the substrate is used. The semiconductor is, for example, of a homostructure, heterostructure or double heterostructure having an MIS junction, PIN junction or PN junction. The light-emitting wavelength may be variously selected in a range of ultraviolet light to infrared light depending on the material of the semiconductor layer and the mixture ratio thereof.

The transparent resin 160 is preferably a thermosetting resin. The transparent resin 160 is preferably made of at least one selected from the group consisting of themosetting resins such as epoxy resin, modified epoxy resin, silicone resin, modified silicone resin, acrylate resin, urethane resin and polyimide resin. Epoxy resin, modified epoxy resin, silicone resin and modified silicone resin are particularly preferred. The transparent resin 160 is preferably hard in order to protect the device 37. A resin having excellent heat resistance, weather resistance and light resistance is preferably used for the transparent resin 160. At least one selected from the group consisting of filler, diffusing agent, pigment, fluorescent material, reflective material, UV absorber and antioxidant may also be mixed into the transparent resin 160 to impart predetermined functions thereto.

The fluorescent particles 150 used should be of a type capable of wavelength conversion of light absorbed from the device 37 to change the wavelength of the light. The fluorescent particles 150 are preferably made of at least one selected from the group consisting of nitride phosphors, oxynitride phosphors, SiAlON phosphors and β-SiAlON phosphors mainly activated by lanthanoid elements such as Eu and Ce; alkaline-earth halogen apatite phosphors mainly activated by lanthanoid elements such as Eu and transition metal elements such as Mn; alkaline-dearth metal borate halogen phosphors; alkaline-earth metal aluminate phosphors; alkaline-earth silicate phosphors; alkaline-earth sulfide phosphors; alkaline-earth thiagallate phosphors; alkaline-earth silicon nitride phosphors; germanate phosphors; rare-earth aluminate phosphors mainly activated by lanthanoid elements such as Ce; rare-earth silicate phosphors; and organic compounds and organic complexes mainly activated by lanthanoid elements such as Eu.

As described above, the light reflecting substrate of the invention may also be used as a light reflecting substrate of a phosphor color mixed type white LED light-emitting device which uses a UV to blue LED and a fluorescent emitter which absorbs light from the UV to blue LED and emits fluorescence in a visible light region.

The fluorescent emitter absorbs blue light from the blue LED to emit fluorescence (yellow fluorescence) and the fluorescence and afterglow of the blue LED cause the light-emitting device to emit white light.

This is of a so-called "pseudo-white light-emitting type" which uses a blue LED chip as the light source and a yellow phosphor in combination. The light reflecting substrate of the invention may be used in the substrate of the light-emitting device in a light-emitting unit which uses other known light-emitting systems such as "UV to near-UV light source type" which uses a UV to near-UV LED chip as the light source and several types of red/green/blue phosphors in combination, and "RGB light source type" which emits white light from the three light sources of red, green and blue colors.

The substrate of the invention may be subjected to a protective treatment against various solvents used in the posttreatments to be described later including formation of a metal interconnect layer for transmitting electric signals to the LED, patterning and formation of a metal layer in the LED mounting area.

More specifically, in the protective treatment, the surface properties of the anodized film including hydrophilicity and hydrophobicity (lipophilicity and lipophobicity) can be appropriately changed as described in, for example, JP 2008-93652 A and JP 2009-68076 A. In addition, a method of imparting the resistance to acids and alkalis may also be appropriately used.

8. <Formation of metal interconnect layer>

In the reflecting substrate according to the invention, a metal interconnect layer for actually transmitting an electrical signal to an LED can be formed in mounting the LED.

The material is not particularly limited, as long as it is an electrically-conductive material. Metal materials such as gold (Au), silver (Ag), copper (Cu), aluminum (Al), magnesium (Mg), and nickel (Ni) can be preferably used. These metal materials may be used singly or in combinations thereof.

The thickness of the metal layer is preferably in the range of 0.5 μm to 1000 μm, more preferably in the range of 1 μm to 500 μm, and particularly preferably in the range of 5 μm to 250 μm, from the viewpoints of conduction reliability and compactness of a package.

Examples of the method of forming the above-mentioned metal layer includes various plating processes such as electrolytic plating, electroless plating, and displacement plating, a sputtering process, a vapor deposition process, a vacuum-attachment process of a metal foil, and a bonding process with an adhesive layer. The formation of a layer out of only metal is preferable from the viewpoint of high heat resistance and the layer formation using the plating is particularly preferable from the viewpoints of uniform thickness and high close adhesion.

The thus formed metal interconnect layer is patterned by any known method according to the LED mounting design. A metal layer (including a solder) may be formed again in the portion where the LED is to be actually mounted, and appropriately processed by thermocompression bonding, flip-chip bonding or wire bonding for easier connection.

The suitable metal layer is preferably made of metal materials such as solder, gold (Au), silver (Ag), copper (Cu), aluminum (Al), magnesium (Mg) and nickel (Ni). In terms of the LED mounting under heating, a method of soldering or applying gold or silver through nickel is preferred for the connection reliability.

These mounting methods involve heating, and in the mounting method involving thermocompression bonding including reflow soldering and flip chip bonding, the maximum temperature reached is preferably from 220°C to 350°C, more preferably from 240°C to 320°C and most preferably from 260°C to 300°C in terms of uniform and reliable mounting. The maximum temperature reached is preferably kept for 2 seconds to 10 minutes, more preferably 5 seconds to 5 minutes and most preferably 10 seconds to 3 minutes for the same reason as above.

In order to prevent cracks from occurring in the anodized aluminum layer during the thermal treatment due to a difference in the coefficient of thermal expansion between the aluminum layer and the anodized aluminum layer in the substrate of the invention, a heat treatment may also be performed before reaching the maximum temperature at a desired constant temperature for preferably 5 seconds to 10 minutes, more preferably 10 seconds to 5 minutes and most preferably 20 seconds to 3 minutes. In this case, the desired constant temperature is preferably from 80°C to 200°C, more preferably from 100°C to 180°C and most preferably from 120°C to 160°C. At treatment temperature and time of less than the defined ranges, the light-emitting device may not be satisfactorily mounted, whereas at treatment temperature and time exceeding the defined ranges, the substrate may deteriorate.

The light-emitting device is mounted by wire bonding at a temperature of preferably 80°C to 300°C, more preferably 90°C to 250°C and most preferably 100°C to 200°C in terms of reliable mounting also in the case. The heating time is preferably 2 seconds to 10 minutes, more preferably 5 seconds to 5 minutes and most preferably 10 seconds to 3 minutes. At treatment temperature and time of less than the defined ranges, wire bonding may not be sufficient, whereas at treatment temperature and time exceeding the defined ranges, the substrate may deteriorate.

EXAMPLES

The invention is described below more specifically by way of examples. However, the invention should not be construed as being limited to the following examples.

(Examples 1 to 6 and Comparative Example 1)

1. Preparation of Aluminum Reflecting Substrate

A melt was prepared from an aluminum alloy composed of 0.06 wt% silicon, 0.30 wt% iron, 0.005 wt% copper, 0.001 wt% manganese, 0.001 wt% magnesium, 0.001 wt% zinc and 0.03 wt% titanium, with the balance being aluminum and inevitable impurities. The aluminum alloy melt was subjected to molten metal treatment and filtration, then was cast into a 500 mm thick, 1,200 mm wide ingot by a direct chill casting process. The ingot was scalped with a scalping machine, removing on average 10 mm of material from the surface, then soaked and held at 550°C for about 5 hours. When the temperature had fallen to 400°C, the ingot was rolled with a hot rolling mill to a plate thickness of 2.7 mm. In addition, heat treatment was carried out at 500°C in a continuous annealing furnace, after which cold rolling was carried out to finish the aluminum plate to a thickness of 0.24 mm thereby obtaining a JIS 1050 aluminum plate. This aluminum plate was cut into a width of 1030 mm and subjected to the surface treatments described below to yield aluminum reflecting substrates.

Of the following surface treatments (a) to (j), those indicated with "YES" in Table 1 was successively carried out on the aluminum plates in order from the left side of Table 1. Note that nip rollers were used to remove the solution or water after each treatment or rinsing treatment was carried out.

(a) Mechanical Graining Treatment

The apparatus as shown in FIG. 4 was used to carry out mechanical graining treatment which involved rotating nylon brush rollers while an aqueous suspension containing an abrasive (pumice) (specific gravity: 1.12) was supplied to the surface of each aluminum plate as the abrasive slurry. FIG. 4 shows an aluminum plate 1, brush rollers 2 and 4, an abrasive slurry 3, and support rollers 5, 6, 7 and 8. The abrasive had an average particle size of 40 $\mu$m and a maximum particle size of 100 $\mu$m. The nylon brush was made of nylon 6.10 and had a bristle length of 50 mm and a bristle diameter of 0.3 mm. For the nylon brush, the bristles were tightly packed in holes formed in a stainless steel cylinder having a diameter of 300 mm. Three rotating brush rollers were used. The distance between the two support rollers (diameter: 200 mm) under each of the brush rollers was 300 mm. The brush rollers were pressed against an aluminum plate until the load of the drive motor for rotating the brush rollers increased by 7 kW from the state in which the brush rollers had not yet been pressed against the aluminum plate. The direction of rotation of the brush roller was the same as the direction in which the aluminum plate was moved. The brush rollers were rotated at 200 rpm.

(b) Alkali Etching Treatment

Etching was carried out by spraying each aluminum plate with an aqueous solution having a sodium hydroxide concentration of 2.6 wt%, an aluminum ion concentration of 6.5 wt% and a temperature of 70°C, whereby 6 g/m$^2$ of material was dissolved out of the aluminum plate. Then, each aluminum plate was sprayed with water for rinsing.

(c) Desmutting Treatment

Desmutting was carried out by spraying each aluminum plate with an aqueous solution having a nitric acid concentration of 1 wt%, an aluminum ion concentration of 0.5 wt% and a temperature of 30°C. Thereafter, each aluminum plate was sprayed with water for rinsing. Wastewater from the electrochemical graining treatment step carried out with an alternating current in a nitric acid aqueous solution was used as the nitric acid aqueous solution for desmutting treatment.

(d) Electrochemical Graining Treatment

An alternating current with a frequency of 60Hz was continuously passed through each aluminum plate to carry out electrochemical graining treatment. An aqueous solution containing 10.5 g/L of nitric acid, 5 g/L of aluminum ions and 0.007 wt% of ammonium ions was used as the electrolytic solution at a temperature of 50°C. Electrochemical graining treatment was carried out for a period of time TP until the current reached a peak from zero of 0.8 ms, at a duty ratio of 1:1, using an alternating current having a trapezoidal waveform, and a carbon electrode as the counter electrode. Ferrite was used for the auxiliary anodes. The electrolytic cell as shown in FIG. 2 was used. The current density at the current peaks was 30 A/dm$^2$. The total amount of electricity when the aluminum plate served as an anode was 220 C/dm$^2$. To the auxiliary anodes was diverted 5% of the current from the power supply. Then, each aluminum plate was sprayed with water for rinsing.

(e) Alkali Etching Treatment

Etching was carried out by spraying each aluminum plate with an aqueous solution having a sodium hydroxide concentration of 26 wt% and an aluminum ion concentration of 6.5 wt% at a temperature of 32°C, whereby 1.0 g/m$^2$ of material was dissolved out of the aluminum plate. Thus, the aluminum hydroxide-based smut component generated when electrochemical graining treatment was carried out using the alternating current in the previous step was removed, and edges of pits formed by electrochemical graining treatment were dissolved and given smooth surfaces. Then, each aluminum plate was sprayed with water for rinsing.

(f) Desmutting Treatment

Desmutting was carried out by spraying each aluminum plate with an aqueous solution having a sulfuric acid concentration of 15 wt%, an aluminum ion concentration of 4.5 wt% and a temperature of 30°C. Thereafter, each aluminum plate was sprayed with water for rinsing. Wastewater from the electrochemical graining treatment step carried out with an alternating current in a nitric acid aqueous solution was used as the nitric acid aqueous solution for desmutting treatment.

(g) Electrochemical Graining Treatment

An alternating current with a frequency of 60Hz was continuously passed through each aluminum plate to carry out electrochemical graining treatment. An aqueous solution containing 7.5 g/L of hydrochloric acid and 5 g/L of aluminum ions was used as the electrolytic solution at a temperature of 35°C. An alternating current having a waveform as shown in FIG 1 was applied and electrochemical graining treatment was carried out for a period of time TP until the current reached a peak from zero of 0.8 ms, at a duty ratio of 1:1, using an alternating current having the trapezoidal waveform, and a carbon electrode as the counter electrode. Ferrite was used for the auxiliary anodes. The electrolytic cell as shown in FIG. 2 was used. The current density at the current peaks was 25 A/dm$^2$. The total amount of electricity when the aluminum plate served as an anode was 50 C/dm$^2$. Then, each aluminum plate was sprayed with water for rinsing.

(h) Alkali Etching Treatment

Etching was carried out by spraying each aluminum plate with an aqueous solution having a sodium hydroxide concentration of 26 wt% and an aluminum ion concentration of 6.5 wt% at a temperature of 32°C, whereby 0.1 g/m$^2$ of material was dissolved out of the aluminum plate. Thus, the aluminum hydroxide-based smut component generated when electrochemical graining treatment was carried out using the alternating current in the previous step was removed, and edges of pits formed by electrochemical graining treatment were dissolved and given smooth surfaces. Then, each aluminum plate was sprayed with water for rinsing.

(i) Desmutting Treatment

Desmutting was carried out by spraying each aluminum plate with an aqueous solution having a sulfuric acid concentration of 25 wt%, an aluminum ion concentration of 0.5 wt% and a temperature of 60°C. Thereafter, each aluminum plate was sprayed with water for rinsing.

The surface-treated aluminum plate obtained was drilled to form through-holes and subjected to routing to obtain pieces with a final size of 3.2 mm x 2.8 mm. The amount of volume expansion due to anodization to be subsequently performed was preliminarily measured to determine the size and the aluminum plate was processed so as to have the determined size.

(j) Anodizing Treatment

An anodizing apparatus of the structure as shown in FIG. 3 was used to carry out anodizing treatment. Oxalic acid was used for the electrolytic solution to supply to a first and a second electrolysis portion. Each electrolytic solution contained 60 g/L of oxalic acid and 0.5 wt% of aluminum ions and had a temperature of 38°C. Then, each aluminum plate was sprayed with water for rinsing. The final thickness of the anodized film was 10 $\mu$m.

(Example 7)

Example 6 was repeated except that (j) Anodizing Treatment in 1. Preparation of Aluminum Reflecting Substrate as mentioned above was performed by the following procedure.
More specifically, the aluminum plate was treated with a solution having a sulfuric acid concentration of 60 g/L at a temperature of 15°C and a constant voltage of 25 V for 70 minutes and then with a mixed aqueous solution containing 30 g/L of boric acid and 20 g/L of sodium tetraborate at a temperature of 20°C for 5 minutes to form an anodized film with a thickness of 9 $\mu$m.

(Example 8)

The anodized film of the substrate in Example 7 obtained as above was subjected to (k) Oxide Layer Forming Treatment to further apply the coating liquid (A) shown below to a film thickness of 1 $\mu$n. Then, the coating liquid was heated at 100°C for 1 minute to form a sol-gel layer.

Coating liquid (A)

| | |
|---|---|
| * Tetraethyl orthosilicate | 50.00 g |
| * Concentrated nitric acid | 0.05 g |
| * Pure water | 21.60 g |
| * Methanol | 10.80 g |

(Example 9)

The anodized film of the substrate in Example 7 obtained as above was subjected to (k) Oxide Layer Forming Treatment to further apply the coating liquid (B) shown below to a film thickness of 1 $\mu$m. Then, the coating liquid was heated at 100°C for 1 minute to form a sol-gel layer.

Coating liquid (B)

| | |
|---|---|
| * Tetraethyl orthosilicate | 50.00 g |
| * Concentrated nitric acid | 0.05 g |
| * Titanium oxide | 1.00 g |
| * Pure water | 21.60 g |
| * Methanol | 10.80 g |

(Comparative Example 1)

The aluminum plate used in Example 1 was used and (j) Anodizing Treatment was only performed.

2. Measurement of Surface Profile of Porous Alumina Light Reflecting Substrate

Measurement as indicated in (1) to (3) below was performed on the surface pits of the light reflecting substrate obtained as above to calculate the respective average wavelengths of the large-, medium- and small-wave structures. The results are shown in Table 1. In Table 1, a dash "-" indicates that there were no irregularities of a corresponding average wavelength.

(1) Average Wavelength of Large-Wave Structure

Two-dimensional roughness measurement was conducted using a stylus-type roughness tester (Surfcom 575 manufactured by Tokyo Seimitsu Co., Ltd.). The mean spacing $S_m$ as defined by ISO 4287 was measured five times, and the mean of the five measurements was used as the value of the average wavelength.
The conditions of the two-dimensional roughness measurement are described below.

<Measurement conditions>

Cutoff value, 0.8 mm; slope correction, FLAT-ML; measurement length, 3 mm; vertical magnification, 10,000X; scan rate, 0.3 mm/s; stylus tip diameter, 2 $\mu$m.

(2) Average Wavelength of Medium-Wave Structure

A surface image of each porous alumina support was taken from just above with SEM at a magnification of 2,000X. From the SEM image obtained, 50 pits of the medium-wave structure which were connected to one another in an annular shape were extracted and their diameters were read for the wavelength. The average wavelength was then calculated.

(3) Average Wavelength of Small-Wave Structure

A surface image of each porous alumina support was taken from just above with a high-resolution SEM at a magnification of 50,000X, and 50 pits of the small-wave structure were extracted from the SEM image obtained. Their diameters were read for the wavelength and the average wavelength was then calculated.

3. Calculation of Factor for Surface Profile of Porous Alumina Light Reflecting Substrate

The surface profile was measured with an atomic force microscope (SP13700 manufactured by Seiko Instruments & Electronics Ltd.) to obtain three-dimensional data, thereby determining the difference in surface area $\Delta S$ on the surface of each porous alumina obtained as above. The procedure is described below in further detail.
A 1cm square sample was cut out from the porous alumina and placed on a horizontal sample holder on a piezo scanner. A cantilever was made to approach the surface of the sample. When the cantilever reached the zone where interatomic forces were appreciable, the surface of the sample was scanned in the X and Y directions and the surface topography of the sample was read based on the displacement in the Z direction. The piezo scanner used was capable of scanning 150 $\mu$m, in the X and Y directions and 10 $\mu$m in the Z direction. The cantilever used had a resonance frequency of 120 to 150 kHz and a spring constant of 12 to 20 N/m (SI-DF20 manufactured by NANOPROBE). Measurement was carried out in the dynamic force mode (DFM). The three-dimensional data obtained was approximated by the least-squares method to compensate for slight tilting of the sample and determine a reference plane.
Measurement involved obtaining values of 50 $\mu$m square regions of the surface of the sample at 512 by 512 points. The resolution was 1.9 $\mu$m in the X and Y directions, and 1 nm in the Z direction, and the scan rate was 60 $\mu$m/s.
The three-dimensional data (f(x,y)) obtained above was used to extract sets of adjacent three points. The surface areas of microtriangles formed by the sets of three points were summated, thereby giving the actual surface area $S_x$. The difference in surface area $\Delta S$ was then calculated from the resulting actual surface area $S_x$ and the geometrically measured surface area So (50 $\mu$m $\times$ 50 $\mu$m) using the equation (1) as defined in the specification.
The results are shown in Table 1-2.

4. Measurement of Light Reflectivity

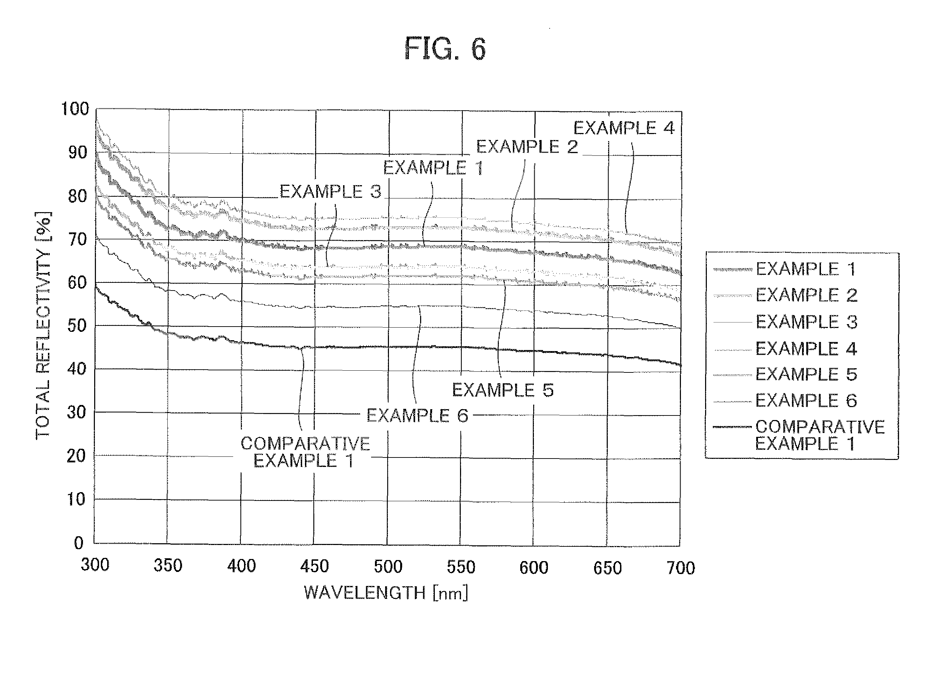

The total reflectivity of 300 to 700 nm of obtained light reflecting substrates of the examples and the comparative example was measured for every 10 nm by the use of SP60 made by X-Rite Inc. The results are shown in FIGS. 6 and 8.

5. Evaluation of brightness in LED device mounted unit

The brightness of phosphor color mixed type white LED light-emitting units employing the obtained light reflecting substrates of the examples and the comparative example was evaluated as follows.

That is, the light reflecting substrates of the examples and the comparative example were installed as the light reflecting substrate 140 so as to come in contact with the blue LED 110 of the light-emitting unit 100 shown in FIG. 5 and the brightness values of the light-emitting units when the blue LED 110 is driven with 6 V were compared.

As a result, the light-emitting unit using the micro structure of Example 1 as the light emitting substrate was improved in brightness by 1.1 to 1.3 times, compared with the light-emitting unit using the substrate of Comparative Example 1.

[Table 1] Table 1

Table 1

| | Treatment | | | | | | | | | | |
|---|---|---|---|---|---|---|---|---|---|---|---|
| | (a) | (b) | (c) | (d) | (e) | (f) | (g) | (h) | (i) | (j) | (k) |
| Example 1 | YES | YES | YES | YES | YES | YES | YES | YES | YES | YES | |
| Example 2 | YES | YES | YES | YES | YES | YES | | | | YES | |
| Example 3 | YES | YES | YES | | | | YES | YES | YES | YES | |
| Example 4 | | | | YES | YES | YES | YES | YES | YES | YES | |
| Example 5 | YES | YES | YES | | | | | | | YES | |
| Example 6 | | | | YES | YES | YES | | | | YES | |
| Example 7 | | | | YES | YES | YES | | | | YES | |
| Example 8 | | | | YES | YES | YES | | | | YES | YES |
| Example 9 | | | | YES | YES | YES | | | | YES | YES |
| Comparative Example 1 | | | | | | | | | | YES | |

[Table 2]

Table 2

| | ΔS(%) | Average wavelength(mm) | | |
|---|---|---|---|---|
| | | Large-wave structure | Medium-wave structure | Small-wave structure |
| Example 1 | 54 | 20 | 2.0 | 0.08 |
| Example 2 | 25 | 20 | 2.0 | - |
| Example 3 | 40 | 20 | - | 0.08 |
| Example 4 | 42 | - | 2.0 | 0.08 |
| Example 5 | 11 | 20 | - | - |
| Example 6 | 13 | - | 2.0 | - |
| Example 7 | 20 | - | 2.0 | - |
| Example 8 | 8 | - | 2.0 | - |
| Example 9 | 8 | - | 2.0 | - |
| Comparative Example 1 | 4 | - | - | - |

6. Evaluation of light directivity in LED device mounted unit

Similarly to the above 5, the phosphor color mixed type white LED light-emitting units were manufactured using the obtained light reflecting substrates of the examples and the comparative example and the light directivity of the light reflecting substrates was evaluated. That is, the average reflectivity of 400 to 700 nm when the viewing angle for measuring reflected light is set to 175 degrees and 120 degrees was obtained by the use of a multi-spectral goniophotometer. The results are shown in Table 3. In general, it is desirable to design an LED light-emitting member so as to enhance the directivity in the direction perpendicular to the light-emitting surface, and the light-emitting units using the light reflecting substrates of the examples of the invention have small dependency on the viewing angle (the difference in reflectivity depending on the viewing angle is small) and has an excellent light reflection characteristic.

[Table 3]

Table 3

| | 400-700 nm Average reflectivity [%] | |
|---|---|---|
| | Viewing angle 175 [deg] | Viewing angle 120 [deg] |
| Example 1 | 68 | 67 |
| Example 2 | 73 | 72 |
| Example 3 | 64 | 61 |
| Example 4 | 74 | 73 |
| Example 5 | 62 | 60 |
| Example 6 | 54 | 53 |
| Example 7 | 62 | 60 |
| Example 8 | 60 | 58 |
| Example 9 | 73 | 72 |
| Comparative Example 1 | 45 | 28 |

(Example 10)

6. Preparation of LED device mounted unit by superimposing two sheets of LED mounting (lower) substrate and through-hole (upper) substrate

The light reflecting substrate manufactured in Example 1 was used as an LED mounting (lower) substrate. Regarding the through-hole (upper) substrate, the same surface treatment and anodizing treatment as in Example 1 were performed except that a through-hole is preliminarily formed in an aluminum plate through drilling, to form a through-hole (upper) substrate. Specifically, a 0.5 mmφ through-hole was formed in an aluminum plate with a thickness of 0.24 mm at 1500 rpm for a processing time of 20 seconds through the use of a drill formed of tungsten carbide. The resultant two aluminum light reflecting substrates were bonded with an epoxy-based adhesive, the resultant was cut out by dicing treatment so as to be 3.2x2.8 mm centered on the 0.5 mmφ through-hole, whereby a mounting substrate having the cavity structure was prepared. A 0.3 mm square blue LED and an electrical interconnect with a width of 100 μm for supplying an electrical signal to the LED were disposed in the through-hole of the mounting substrate having the cavity structure and were connected by wire bonding, whereby an LED device mounted unit was obtained.

DESCRIPTION OF SYMBOLS

1, 11 aluminum plate
2, 4 brush roller
3 abrasive slurry
5, 6, 7, 8 support roller
12 radial drum roller
13a, 13b main electrode
14 electrolytic treatment solution
15 solution feed inlet
16 slit
17 solution channel

18 auxiliary anode
19a, 19b thyristor
20 AC power supply
22 blue LED
24 resin
26 fluorescence emission unit
30, 301, 303 light reflecting substrate
32, 321 insulating layer
33, 331 metal layer
34 pit (cavity)
35 through-hole
36 mold
37 device
39 heat sink
40 main electrolytic cell
41 chip
42 joint portion
43 cutout portion
45 cut edge
50 auxiliary anode cell
410 anodizing apparatus
412 power supply cell
414 electrolytic cell
416 aluminum plate
418, 426 electrolytic solution
420 power supply electrode
422, 428 roller
424 nip roller
430 electrolytic electrode
432 cell wall
434 dc power supply
100 light-emitting unit
110 blue LED
120, 130 electrode
140 light reflecting substrate
150 fluorescent particle
160 transparent resin

**Claims**

1.  A light reflecting substrate comprising at least:

    an insulating layer; and
    a metal layer disposed in contact with the insulating layer,
    wherein the total reflectivity of light in the wavelength range of more than 320 nm and not more than 700 nm is not less than 50% and the total reflectivity of light in the wavelength range of 300 nm to 320 nm is not less than 60%.

2.  The light reflecting substrate according to claim 1, wherein a surface of the light reflecting substrate has irregularities having an average wavelength of 0.01 to 100 $\mu$m.

3.  The light reflecting substrate according to claim 1 or 2, wherein a difference in surface area $\Delta S$ calculated by formula (1) is not less than 5% and not more than 90%:

$$\Delta S = [(S_x - S_0)/S_0] \times 100 \ (\%) \quad (1)$$

where $S_x$ represents the actual surface area of a 50 $\mu$mx50 $\mu$m surface region of the light reflecting substrate as determined by three-point approximation from three-dimensional data on the surface region measured with an atomic force microscope at 512×512 points and So represents the geometrically-measured surface area of the surface region.

4. The light reflecting substrate according to any one of claims 1 to 3, wherein the metal layer is aluminum and the insulating layer is an anodized film of the aluminum.

5. The light reflecting substrate according to any one of claims 1 to 4, wherein the light reflecting substrate is a light reflecting substrate reflecting light emitted from a light-emitting device toward an emitted-light observation surface.

6. The light reflecting substrate according to any one of claims 1 to 5, wherein the metal layer has a shape having a pit and the insulating layer is formed on the surface of the shape having the pit.

7. A method of manufacturing the light reflecting substrate according to any one of claims 1 to 6, comprising:

preparing an aluminum plate;
graining a surface of the aluminum plate; and
anodizing the grained surface to form the insulating layer.

8. A method of manufacturing the light reflecting substrate according to any one of claims 1 to 6, comprising at least:

preparing an aluminum plate; and
graining a surface of the aluminum plate and then performing the following steps (a) and (b) in any order:

(a) forming an interconnect through-hole in which a light-emitting device is disposed and performing routing for chipping the substrate; and
(b) anodizing the grained surface to form the insulating layer.

9. The light reflecting substrate according to claim 6, which is formed by superimposing at least two sheets of light reflecting substrates according to any one of claims 1 to 4 in which at least one through-hole is formed in one aluminum plate and no through-hole is formed in the other aluminum plate.

10. The method of manufacturing a light reflecting substrate according to claim 8, wherein when the routing is performed so that a cutout portion for individually cutting chips is formed around a plurality of chips and a joint portion connecting the plurality of chips to the aluminum plate is formed in a part of the cutout portion, the routing includes a routing process of designing a portion of the aluminum plate serving as the joint portion so as to be thinner than a portion serving as a chip, cutting the cutout portion so as to leave the joint portion in the aluminum plate through the routing, then anodizing the aluminum plate, then cutting the joint portion to reduce or remove the area of the aluminum part formed in the thickness direction of the individual chips separated by cutting the joint.

11. The method of manufacturing a light reflecting substrate according to claim 8 or 10, wherein the following steps (c) and (d) are performed in any order after the steps according to claim 8 or 10:

(c) forming a metal interconnect layer for transmitting an electrical signal to a light-emitting device and patterning the metal interconnect layer; and
(d) forming a metal layer in an electrode portion corresponding to a portion on which the light-emitting device is mounted again.

12. A white light-emitting diode device having a blue light-emitting device in an upper layer of the light reflecting substrate according to any one of claims 1 to 6 and claim 9 and having a fluorescent emitter around and/or on the blue light-emitting device.

# FIG. 1

# FIG. 2

## FIG. 3

## FIG. 4

## FIG. 5

FIG. 6

# FIG. 7

# FIG. 8

# FIG. 9

# FIG. 10

(A)

(B1)      (B2)      (B3)

(C1)

(C2)

(C3)

EP 2 448 024 A1

EP 2 448 024 A1

# FIG. 11

(A1)　　ROUTING　　(A2)　　ANODIZATION　　(A3)

WHEN THE ALUMINUM PLATE IS CUT INTO CHIPS

(A4)

(B1)　　ANODIZATION　　CHIPPING

(B2)　　ANODIZATION　　CHIPPING

| INTERNATIONAL SEARCH REPORT | International application No. |
|---|---|
| | PCT/JP2010/060629 |

**A. CLASSIFICATION OF SUBJECT MATTER**
*H01L33/60*(2010.01)i, *H01L33/50*(2010.01)i

According to International Patent Classification (IPC) or to both national classification and IPC

**B. FIELDS SEARCHED**

Minimum documentation searched (classification system followed by classification symbols)
H01L33/00-33/64

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2006-313321 A  (Nippon Sheet Glass Co., Ltd., Nichia Chemical Industries, Ltd.), 16 November 2006 (16.11.2006), paragraphs [0017] to [0030]; fig. 4 to 7 & US 2009/0034296 A1    & WO 2006/107011 A1 & KR 10-2007-0117707 A  & CN 101180744 A | 1-12 |
| Y | JP 2008-300773 A  (Daisho Denshi Co., Ltd.), 11 December 2008 (11.12.2008), paragraphs [0020] to [0035]; fig. 1 to 8 (Family: none) | 1-12 |
| Y | JP 2008-76862 A  (Komaden Corp.), 03 April 2008 (03.04.2008), paragraphs [0015] to [0032]; fig. 1 to 8 & JP 3-927592 B | 1-12 |

| ☒ | Further documents are listed in the continuation of Box C. | ☐ | See patent family annex. |
|---|---|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 20 July, 2010 (20.07.10) | 03 August, 2010 (03.08.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| International application No. |
| --- |
| PCT/JP2010/060629 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 5-232463 A  (Matsushita Electric Works, Ltd.), 10 September 1993 (10.09.1993), paragraphs [0011] to [0015] (Family: none) | 1-12 |
| Y | JP 2007-245116 A  (Fujifilm Corp.), 27 September 2007 (27.09.2007), paragraphs [0008] to [0126]; tables 1, 2; fig. 1 to 4 & US 2007/0219092 A1 | 2-12 |
| Y | JP 2009-81196 A  (Sanyo Electric Co., Ltd., Sanyo Semiconductor Co., Ltd., Sanyo Consumer Electronics Co., Ltd.), 16 April 2009 (16.04.2009), paragraphs [0010] to [0076]; fig. 1 to 12 & US 2009/0078455 A1     & CN 101404276 A | 6-12 |
| Y | JP 2008-53663 A  (Matsushita Electric Works, Ltd.), 06 March 2008 (06.03.2008), paragraphs [0073] to [0093]; fig. 17 to 22 (Family: none) | 8-12 |
| Y | JP 2008-130735 A  (CI Kasei Co., Ltd.), 05 June 2008 (05.06.2008), paragraphs [0045] to [0050]; fig. 4, 5 (Family: none) | 8-12 |
| Y | JP 2009-81195 A  (Sanyo Electric Co., Ltd., Sanyo Semiconductor Co., Ltd., Sanyo Consumer Electronics Co., Ltd.), 16 April 2009 (16.04.2009), paragraphs [0009] to [0069]; fig. 1 to 10 (Family: none) | 9,11,12 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2998696 B
- JP 11087784 A
- JP 2006100753 A
- JP 59153861 A
- JP 61051395 A
- JP 62146694 A
- JP 60215725 A
- JP 60215726 A
- JP 60215727 A
- JP 60216728 A
- JP 61272367 A
- JP 58011759 A
- JP 58042493 A
- JP 58221254 A
- JP 62148295 A
- JP 4254545 A
- JP 4165041 A
- JP 3068939 B
- JP 3234594 A
- JP 1047545 B
- JP 62140894 A
- JP 1035910 B
- JP 55028874 B
- JP 7081264 A
- JP 7305133 A
- JP 8049034 A
- JP 8073974 A
- JP 8108659 A
- JP 62005080 B
- JP 63060823 B
- JP 3061753 B
- JP 60203496 A
- JP 60203497 A
- JP 3011635 B
- JP 61274993 A
- JP 62023794 A
- JP 63047347 A
- JP 63047348 A
- JP 63047349 A
- JP 64001293 A
- JP 63135294 A
- JP 63087288 A
- JP 4073392 B
- JP 7100844 B
- JP 62149856 A
- JP 4073394 B
- JP 62181191 A
- JP 5076530 B
- JP 63030294 A
- JP 6037116 B
- JP 2215599 A
- JP 61201747 A
- JP 60230951 A
- JP 1306288 A
- JP 2293189 A
- JP 54042284 B
- JP 4019290 B
- JP 4019291 B
- JP 4019292 B
- JP 61035995 A
- JP 6451992 A
- JP 4226394 A
- US 5009722 A
- US 5028276 A
- JP 62086143 A
- JP 3222796 A
- JP 63060824 B
- JP 60063346 A
- JP 60063347 A
- JP 1293350 A
- EP 223737 B
- US 4818300 A
- GB 1222777 A
- JP 63015978 B
- JP 63143234 A
- JP 63143235 A
- GB 1421710 A
- JP 6057432 A
- JP 3162530 A
- JP 5140659 A
- JP 4231425 A
- JP 4276031 A
- JP 5311261 A
- JP 6136466 A
- JP 5051659 A
- JP 5049148 U
- JP 7040017 A
- JP 3079798 A
- JP 5201166 A
- JP 5156414 A
- JP 6262203 A
- JP 6122949 A
- JP 6210406 A
- JP 6026308 A
- JP 6220593 A
- JP 6210308 A
- JP 7054111 A
- JP 8092709 A

- JP 6218495 A
- JP 7039906 A
- JP 6048058 A
- JP 5301478 A
- JP 7132689 A
- JP 7138687 A
- JP 6135175 A
- JP 50040047 B
- JP 55074898 A
- JP 60036195 A
- JP 6055871 A
- JP 6024168 A
- JP 3008635 A
- JP 3066404 A
- JP 63065017 A
- JP 61162351 A
- JP 63104889 A
- JP 48028123 B
- GB 896563 A
- JP 52058602 A
- JP 3079799 A
- JP 55158298 A
- JP 56028898 A
- JP 52152302 A
- JP 54085802 A
- JP 60190392 A
- JP 58120531 A
- JP 63176187 A
- JP 1005889 A
- JP 1280590 A
- JP 1118489 A
- JP 1148592 A
- JP 1178496 A
- JP 1188315 A
- JP 1154797 A
- JP 2235794 A
- JP 3260100 A
- JP 3253600 A
- JP 4072079 A
- JP 4072098 A
- JP 3267400 A
- JP 1141094 A
- US 4276129 A
- US 9676879 B
- US 4203637 A
- JP 56123400 A
- JP 57059770 A
- JP 53012738 A
- JP 53032821 A
- JP 53032822 A
- JP 53032823 A
- JP 55122896 A
- JP 55132884 A
- JP 62127500 A
- JP 1052100 A
- JP 1052098 A
- JP 60067700 A

- JP 1230800 A
- JP 3257199 A
- JP 53012739 A
- JP 53032833 A
- JP 53032824 A
- JP 53032825 A
- JP 51007081 B
- JP 52133838 A
- JP 52133840 A
- JP 52133844 A
- JP 52133845 A
- JP 53149135 A
- JP 54146234 A
- US 4671859 A
- US 4661219 A
- US 4618405 A
- US 4600482 A
- US 4566960 A
- US 4566958 A
- US 4566959 A
- US 4416972 A
- US 4374710 A
- US 4336113 A
- US 4184932 A
- JP 5195300 A
- JP 54081133 A
- JP 57047894 A
- JP 57051289 A
- JP 57051290 A
- JP 57054300 A
- JP 57136596 A
- JP 58107498 A
- JP 60200256 A
- JP 62136596 A
- JP 63176494 A
- JP 4176897 A
- JP 4280997 A
- JP 6207299 A
- JP 5024377 A
- JP 5032083 A
- JP 5125597 A
- JP 5195291 A
- JP 54012853 A
- JP 48045303 A
- JP 48026638 A
- JP 47018739 A
- JP 58024517 B
- JP 56012518 B
- JP 4004194 A
- JP 5202496 A
- JP 5179482 A
- JP 6035174 A
- JP 2009134007 A
- JP 2009139261 A
- JP 2008093652 A
- JP 2009068076 A

**Non-patent literature cited in the description**

- Anodizing. Metal Finishing Course B. Metal Finishing Society of Japan, 1969, 195-207

- New Alumite Theory. KALLOS PUBLISHING Co., Ltd, 1997, 95-96